# EUROPEAN PATENT SPECIFICATION

(11) **EP 2 447 971 B1**
(45) Date of publication and mention of the grant of the patent: **23.11.2016**
(21) Application number: 09846565.1
(22) Date of filing: 01.07.2009
(51) Int. Cl.: H01H 13/64, G06F 3/0362, G06F 3/0354, B60K 37/06, H03K 17/968, H03K 17/97, H01H 25/04

(54) **COMBINED SWITCH UNIT AND COMBINED SWITCH MODULE HAVING SAME**
KOMBINIERTE SCHALTEREINHEIT UND KOMBINIERTES SCHALTMODUL DAMIT
UNITÉ DE COMMUTATEUR COMBINÉ ET MODULE DE COMMUTATEUR COMBINÉ LA COMPRENANT

(30) Priority: 23.06.2009 KR 20090055768
(43) Date of publication of application: 02.05.2012
(73) Proprietor: Daesung Electric Co., Ltd, Gyeonggi-do 425-851 (KR)
(72) Inventor: HAN, Chang Kyu, Seoul 152-795 (KR); LEE, Jin Young, Gyeonggi-do 426-180 (KR); KWON, Dae Woo, Gyeonggi-do 441-751 (KR); JUNG, Lee Hwa, Gyeonggi-do 445-160 (KR); GOHNG, Jun Ho, Gyeonggi-do 463-749 (KR)
(74) Representative: Ter Meer Steinmeister & Partner
(86) International application number: PCT/KR2009/003584
(87) International publication number: WO 2010/150933

(56) References cited:
- EP-A1- 0 893 750
- JP-A- H1 050 178
- KR-A- 20080 106 241
- KR-B1- 100 386 353
- KR-B1- 100 711 139
- US-A1- 2004 060 807
- US-A1- 2006 012 584
- US-A1- 2008 251 371
- US-A1- 2009 134 003

## Description

### TECHNICAL FIELD

The present invention relate to a switch device, and particularly to, a multi-directional combined switch device that is structured to support a directional movement to enable various operation modes to be selected for a relevant device, and a combined switch module including the same.

### BACKGROUND ART

A switch device comprising the features of the preamble of claim 1 is disclosed by JP H10 50178 A. Similar switch devices are disclosed by US 2006/012584 A1, US 2004/060807 A1 and EP 0 893 750 A1.

A switch device is used as a device for selection and manipulation for apparatuses such as vehicles, machine tools, terminals, multimedia devices, game machines, and the like. Nevertheless, a variety of researches and developments are also in progress on a switch device for diverse functional
selections of the apparatuses. Examples of such a switch device include a rotary switch enabling axial rotation besides a button switch of a simple push switch type. In addition, a variety of researches and productions are performed on a rotary switch having a structure employing a magnetic attraction force to allow a user to make a haptic perception.

### DISCLOSURE OF INVENTION

### TECHNICAL PROBLEM

Accordingly, the present invention has been made in order to satisfy the above-mentioned necessities, and it is an object of the present invention to provide a combined switch device including a directional support element that can more smoothly and stably select various operation modes of a target apparatus, and a combined switch module including the same.

### TECHNICAL SOLUTION

To achieve the above objects, in one aspect, the present invention provides a combined switch device comprising: a housing; a printed circuit board disposed in the housing; and a switch unit that comprises: a switch knob which is rotatably disposed in the housing in such a fashion as to be exposed at one end thereof to the housing; a switch driving body disposed inside the housing, and connected with the switch knob; a switch supporting unit configured to support the switch driving body with respect to the housing; and a switch including a directional switch disposed on the switch driving body and the printed circuit board and configured to be driven by a motion performed on a plane that is vertical to a rotating axis of the switch knob, and a rotary switch configured to be driven by the central rotation of the rotating axis of the switch knob, wherein the switch supporting unit comprises: a switch driving body-directional support configured to support the switch driving body to enable the switch knob to be moved on the plane that is vertical to the rotating axis; and a switch driving body-elastic support configured to elastically support the movement of the switch knob in the direction of the rotating axis.

In the combined switch device, the switch driving body-directional support may be constructed in a universal joint type.

In the combined switch device, the switch driving body-directional support may comprise a directional support fixing part fixedly disposed in the housing, a directional support frame rotatably mounted to the directional support fixing part, and a directional support body disposed at the outside of the switch driving body and mounted to the directional support frame so as to rotated about an axis perpendicular to a rotating axis of the directional support frame relative to the directional support fixing part.

In the combined switch device, the directional switch may comprise: a directional switch magnet disposed at the outside of the switch driving body; and a the directional switch sensor disposed one side of the printed circuit board to correspond to the directional switch magnet and configured to be driven by the tilting movement of the switch knob.

In the combined switch device, the switch unit may further comprises a switch knob rotary unit comprising a rotary switch rotation roller rotatably disposed on the outer circumference of the switch driving body and a rotary switch rotation roller counterpart disposed at a lower end of the skwich knob and configured to be engaged wth the rotary switch rotation roller in such a fashion as to be rotatable relative to the rotary switch rotation roller.

In the combined switch device, the rotary switch may comprise a rotary switch magnet disposed at the rotary switch rotation roller in such a fashion as to be rotatable together with the rotary switch rotation roller and a rotary switch sensor disposed one side of the printed circuit board to correspond to the rotary switch magnet and configured to be driven by the rotation movement of the switch knob.

The combined switch device may further comprises a sub printed circuit board disposed below the switch knob, wherein the rotary switch comprises a rotary switch encoder disposed below the switch knob and configured to be rotated together with the switch knob, and a rotary switch sensor disposed on one surface of the sub printed circuit board to correspond to the rotary switch encoder.

The combined switch device may further comprises a sub printed circuit board disposed at a lower end of the switch knob, wherein the rotary switch comprises a rotary switch encoder of a slit type mounted at the lower end of the switch knob, and a rotary switch sensor of a photo sensor type disposed on one surface of the sub printed circuit board to correspond to the rotary switch encoder.

In the combined switch device, the switch driving body-elastic support may comprise: a support holder disposed beneath the switch driving body; a support body disposed at the support holder such that the support body can perform its sliding movement; a support elastic part configured to be in close contact at one end thereof with the support holder and at the other end thereof with the support body, and configured to apply an elastic force between the support holder and the support body; and a support body counterpart disposed at the housing to correspond to an end of the support body to allow the support body to perform the tilting movement.

In the combined switch device, the support holder may comprise a support holder enter counterpart disposed thereon so as to be oriented toward the support body, the support body comprises a support body enter counterpart disposed thereon so as to be oriented toward the support holder to correspond to the support holder enter counterpart, and an elastically deformable support enter part is provided between the support holder enter counterpart and the support body enter counterpart.

The combined switch device may further comprises a haptic actuator disposed in the switch driving body so as to be connected to the switch knob.

In the combined switch device, the haptic actuator may be constructed in an electric motor type.

In the combined switch device, the haptic actuator may be constructed in an electromagnet type.

In the combined switch device, the haptic actuator may comprise: a haptic actuator shaft connected with theswitch knob; a haptic actuator housing disposed at the inside of the switch driving body; a haptic actuator bobbin disposed at the inside of the hapctic actuator housing in such a fashion that the haptic actuator shaft movably passes therethrough, the haptic actuator bobbin having a coil wound therearound; and a haptic actuator disk mounted around an end of the haptic actuator shaft and brought into close contact with an end of the haptic actuator housing.

The combined switch device may further comprises a light display unit including an optical lamp for generating and externally outputting light based on an electrical signal of the switch unit.

In the combined switch device, the optical lamp may be a light emitting diode (LED) or an organic light emitting diode (OLED).

In the combined switch device, the switch unit may comprise a switch detent unit comprising a detent block disposed at the inside of the switch driving body and having a detent formed on the inner circumferential surface thereof, a detent body connected to the switch knob and disposed in the detent block so as to pass through the detent block, a detent plunger 2740 movably disposed at the detent body and abutting at one end thereof against the detent block, and a detent elastic member disposed at the detent body in an elastically deformable manner and abutting at one end thereof against the other end of the detent plunger.

In the combined switch device, the switch driving body may be disposed to perform its sliding movement on the plane parallel with the printed circuit board, and the switch driving body-directional support is constructed in a ball joint type.

In the combined switch device, the switch driving body-directional support may comprise a directional support fixing part fixedly disposed in the housing, a directional support shaft rotatably mounted to the directional support fixing part so as to be in close contact with the directional support fixing part, and a directional support body disposed at an end of the switch driving body and connected with an end of the directional support shaft in a relatively movable manner with respect to the directional support shaft.

In the combined switch device, the directional switch may comprise: a directional switch magnet disposed at the outside of the switch driving body; and a the directional switch sensor disposed one side of the printed circuit board to correspond to the directional switch magnet and configured to be driven by the tilting movement of the switch knob.

The combined switch device may further comprises a sub printed circuit board disposed below the switch knob, wherein the rotary switch comprises a rotary switch encoder disposed below the switch knob and configured to be rotated together with the switch knob, and a rotary switch sensor disposed on one surface of the sub printed circuit board to correspond to the rotary switch encoder.

In the combined switch device, the switch driving body-elastic support may comprise: a support holder disposed beneath the switch driving body; a support body disposed at the support holder such that the support body can perform its sliding movement; a support elastic part configured to be in close contact at one end thereof with the support holder and at the other end thereof with the support body, and configured to apply an elastic force between the support holder and the support body; and a support body counterpart disposed at the housing to correspond to an end of the support body to allow the support body to perform the tilting movement.

In the combined switch device, the support holder may comprise a support holder enter counterpart disposed thereon so as to be oriented toward the support body, the support body comprises a support body enter counterpart disposed thereon so as to be oriented toward the support holder to correspond to the support holder enter counterpart, and an elastically deformable support enter part is provided between the support holder enter counterpart and the support body enter counterpart.

The combined switch device may further comprise a haptic actuator disposed in the switch driving body so as to be connected to the switch knob, and the haptic actuator may be constructed in an electric motor type. In addition, in the combined switch device, the haptic actuator may be constructed in an electromagnet type.

In the combined switch device, the haptic actuator may comprise: a haptic actuator shaft connected with theswitch knob; a haptic actuator housing disposed at the inside of the switch driving body; a haptic actuator bobbin disposed at the inside of the hapctic actuator housing in such a fashion that the haptic actuator shaft movably passes therethrough, the haptic actuator bobbin having a coil wound therearound; and a haptic actuator disk mounted around an end of the haptic actuator shaft and brought into close contact with an end of the haptic actuator housing.

The combined switch device may further comprise a light display unit including an optical lamp for generating and externally outputting light based on an electrical signal of the switch unit, and the optical lamp may be a light emitting diode (LED) or an organic light emitting diode (OLED).

In the combined switch device, the switch unit may comprise a switch detent unit comprising a detent block disposed at the inside of the switch driving body and having a detent formed on the inner circumferential surface thereof, a detent body connected to the switch knob and disposed in the detent block so as to pass through the detent block, a detent plunger 2740 movably disposed at the detent body and abutting at one end thereof against the detent block, and a detent elastic member disposed at the detent body in an elastically deformable manner and abutting at one end thereof against the other end of the detent plunger.

In another aspect, the present invention may provide a combined switch device comprising: a housing; a printed circuit board disposed in the housing; and a switch unit that comprises: a switch knob which is rotatably disposed in the housing in such a fashion as to be exposed at one end thereof to the housing; and a rotary switch configured to be driven by the rotation of the switch knob; a light display unit including an optical lamp for generating light corresponding to the operation state of the switch unit.

In the combined switch device, the switch unit may comprise: a switch driving body disposed inside the housing, and connected with the switch knob; a switch supporting unit configured to support the switch driving body with respect to the housing; and a switch including a directional switch disposed on the switch driving body and the printed circuit board and configured to be driven by a motion performed on a plane that is vertical to a rotating axis of the switch knob, and a rotary switch configured to be driven by the central rotation of the rotating axis of the switch knob, wherein the switch supporting unit comprises: a switch driving body-directional support configured to support the switch driving body to enable the switch knob to be moved on the plane that is vertical to the rotating axis; and a switch driving body-elastic support configured to elastically support the movement of the switch knob in the direction of the rotating axis.

In yet another aspect, the present invention may provide a combined switch module comprising: a combined switch device that comprises: a housing; a printed circuit board disposed in the housing; and a switch unit that comprises: a switch knob which is rotatably disposed in the housing in such a fashion as to be exposed at one end thereof to the housing; a switch driving body disposed inside the housing, and connected with the switch knob; a switch supporting unit configured to support the switch driving body with respect to the housing; and a switch including a directional switch disposed on the switch driving body and the printed circuit board and configured to be driven by a motion performed on a plane that is vertical to a rotating axis of the switch knob, and a rotary switch configured to be driven by the central rotation of the rotating axis of the switch knob, wherein the switch supporting unit comprises: a switch driving body-directional support configured to support the switch driving body to enable the switch knob to be moved on the plane that is vertical to the rotating axis; and a switch driving body-elastic support configured to elastically support the movement of the switch knob in the direction of the rotating axis; a module housing in which the combined switch device is mounted; a control unit disposed in the module housing and configured to establish an electrical connection with the combined switch device; a storage unit configured to establish an electrical connection with the control unit and store preset data for an operation mode corresponding to the operation of the combined switch device; and a display unit configured to establish an electrical connection with the control unit and display the operation mode of the combined switch device thereon.

### ADVANTAGEOUS EFFECTS

The combined switch device and a combined switch module including the same according to the present invention as constructed above have the following advantages.

First, the combined switch device and a combined switch module including the same according to the present invention enable stable directional movement and smooth rotary movement of the switch knob so that a predetermined desired switch operation selected by a user can be detected precisely.

Second, the combined switch device and a combined switch module including the same according to the present invention enable smooth manipulation of the switch knob through the switch driving body-directional support of a universal joint structure, and allow for stable directional movement of the switch knob and detection of a change in position of the switch knob.

Third, the combined switch device and a combined switch module including the same according to the present invention implement the sliding movement of the switch driving body through the switch driving body-directional support of a ball joint structure to enable more accurate and smoother directional movement of the switch knob and detection of a change in position of the switch knob.

Fourth, the combined switch device and a combined switch module including the same according to the present invention perform the active or passive haptic information delivery through the haptic actuator or the switch detent unit so that the user can make a haptic perception of the operating state of the combined switch device or a relevant operation mode for a target operating unit which it is desired to control based on the operating state, a relevant manipulation item in the relevant operation mode, and a manipulation amount of the manipulation item.

Fifth, the combined switch device and a combined switch module including the same according to the present invention enable a user to instantaneously make a visual perception of the operating state of the combined switch device or a relevant operation mode for a target operating unit which it is desired to control based on the operating state, a relevant manipulation item in the relevant operation mode, and a manipulation amount of the

While the present invention has been described in connection with the exemplary embodiments illustrated in the drawings, it is merely illustrative and the invention is not limited to these embodiments. It is to be understood that various equivalent modifications and variations of the embodiments can be made by a person having an ordinary skill in the art with-out departing from the scope of the present invention.

### BRIEF DESCRIPTION OF THE DRAWINGS

**FIG. 1** is a schematic perspective view illustrating a combined switch module according to one embodiment of the present invention.
**FIG. 2** is a schematic perspective view illustrating a combined switch device according to one embodiment of the present invention.
**FIG. 3** is a schematic exploded perspective view illustrating a combined switch device according to one embodiment of the present invention.
**FIG. 4** is a schematic cross-sectional perspective view illustrating a combined switch device according to one embodiment of the present invention.
FIGs. 5 to 8 are schematic views illustrating the operational state of a combined switch device according to one embodiment of the present invention.
FIG. 9 is a schematic partial perspective view illustrating a partial element of a combined switch device according to one embodiment of the present invention.
FIG. 10 is a schematic partial cross-sectional perspective view illustrating a partial element of a combined switch device according to one embodiment of the present invention.
FIG. 11 is a schematic cross-sectional view illustrating a normal state in which an external force is not applied to a combined switch device according to one embodiment of the present invention.
FIG. 12 is a schematic cross-sectional view illustrating an operational state in which a combined switch device according to one embodiment of the present invention is tilt.
FIG. 13 is a schematic cross-sectional view illustrating a push enter operational state of a combined switch device according to one embodiment of the present invention.
FIG. 14 is a schematic cross-sectional view illustrating a rotation operational state of a combined switch device according to one embodiment of the present invention.
FIG. 15 is a schematic partial perspective view illustrating an operational state of switch knob rotary unit of a combined switch device according to one embodiment of the present invention.
FIG. 16 is a schematic exploded perspective view illustrating a combined switch device according to another embodiment of the present invention.
FIG. 17 is a schematic cross-sectional perspective view illustrating a combined switch device according to another embodiment of the present invention.
FIG. 18 is a schematic partial cross-sectional perspective view illustrating a combined switch device according to another embodiment of the present invention.
FIG. 19 is a schematic partial cross-sectional view illustrating a haptic actuator 300 of a combined switch device according to another embodiment of the present invention.
FIG. 20 is a schematic exploded perspective view illustrating a combined switch device according to still another embodiment of the present invention.
FIG. 21 is a schematic cross-sectional perspective view illustrating a combined switch device according to still another embodiment of the present invention.
FIGs. 22 and 23 are schematic partial top plan view and partial perspective view illstrating a switch detent unit 270 of a combined switch device according to still another embodiment of the present invention.
FIG. 24 is a schematic exploded perspective view illustrating a combined switch device according to yet another embodiment of the present invention.
FIG. 25 is a schematic cross-sectional perspective view illustrating a combined switch device according to yet another embodiment of the present invention.
FIG. 26 is a schematic partial cross-sectional view illustrating a combined switch device according to yet another embodiment of the present invention.
FIG. 27 is a schematic partial perspective view illustrating a combined switch device according to yet another embodiment of the present invention.
FIG. 28 is a schematic cross-sectional view illustrating a normal state in which an external force is not applied to a combined switch device according to yet another embodiment of the present invention.
FIG. 29 is a schematic cross-sectional view illustrating a sliding movement of a switch knob of a combined switch device according to yet another embodiment of the present invention.
FIG. 30 is a schematic cross-sectional view illustrating a push enter operational state of a combined switch device according to yet another embodiment of the present invention.
FIG. 31 is a schematic exploded perspective view illustrating a combined switch device according to a further embodiment of the present invention.
FIG. 32 is a schematic cross-sectional perspective view illustrating a combined switch device according to a further another embodiment of the present invention.
FIG. 33 is a schematic exploded perspective view illustrating a combined switch device according to a still further embodiment of the present invention.
FIG. 34 is a schematic cross-sectional perspective view illustrating a combined switch device according to a still further embodiment of the present invention.
FIGs. 35 to 38 are a schematic cross-sectional perspective view illustrating a combined switch device according to a yet further embodiment of the present invention, a schematic partial perspective view and a partial top plan view of a partial element of the combined switch device.
FIG. 39 is a schematic partial perspective view illustrating the combined switch device shown in FIG. 35.
FIG. 40 is a schematic block diagram illustrating a combined switch module according to another embodiment of the present invention.
FIGs. 41 to 45 are schematic perspective views illustrating an output state of light having different colors according to the operation mode by a light display unit of a combined switch device according to the present invention.
FIG. 46 is a view illustrating a state of another example of a light display unit of a combined switch device according to the present invention.
FIG. 47 is a schematic view illustrating a user image interface implemented in a display unit of a combined switch module according to the present invention.
FIGs. 48 to 50 are views illustrating a display unit on which an operation mode of a vehicle seat as an operation unit controlled by a combined switch module according to the present invention is displayed as an image.
FIG. 51 is a schematic cross-sectional view illustrating a combined switch device whose optical lamp is implemented as an organic light emitting diode (OLED).

### BEST MODE FOR CARRYING OUT THE INVENTION

Now, preferred embodiments of a combined switch device according to the present invention will be described hereinafter in detail with reference to the accompanying drawings.

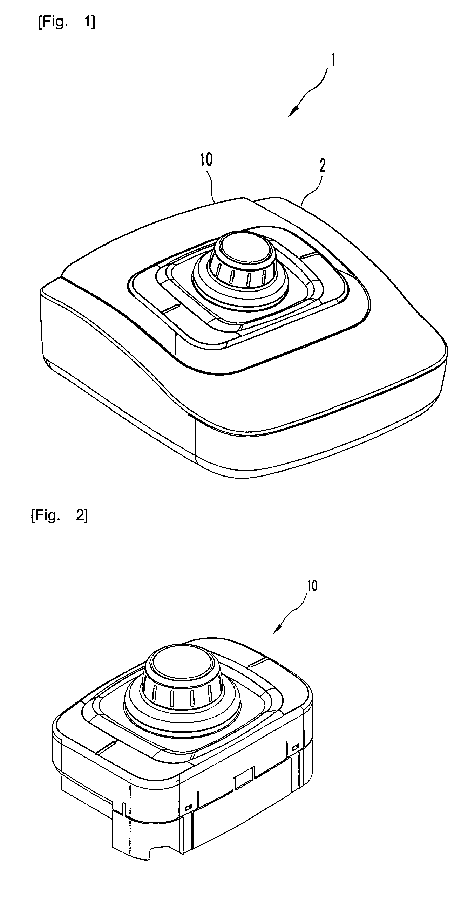

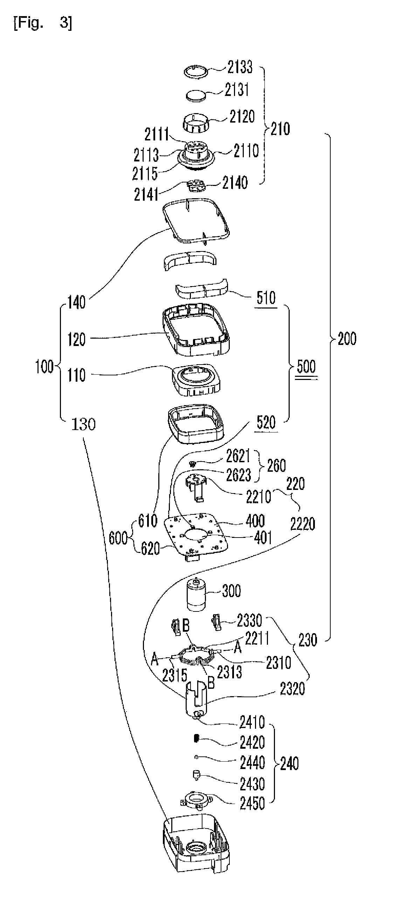

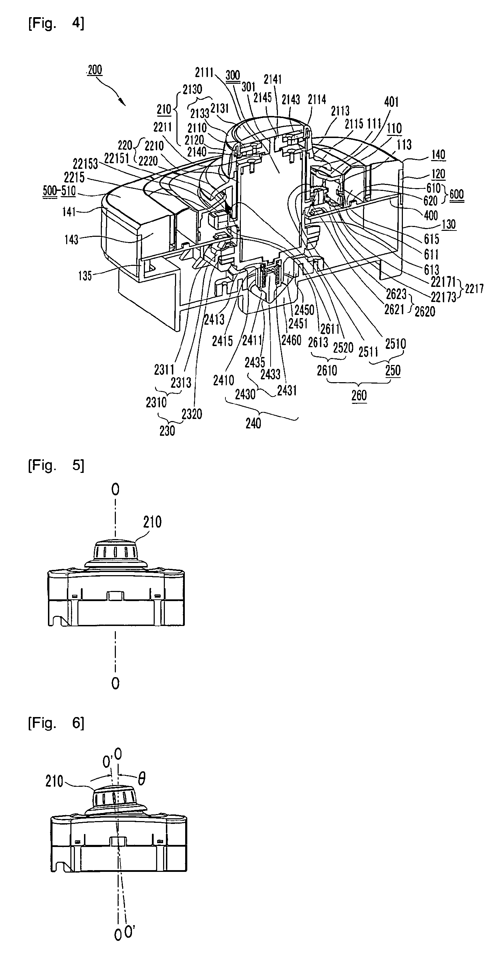

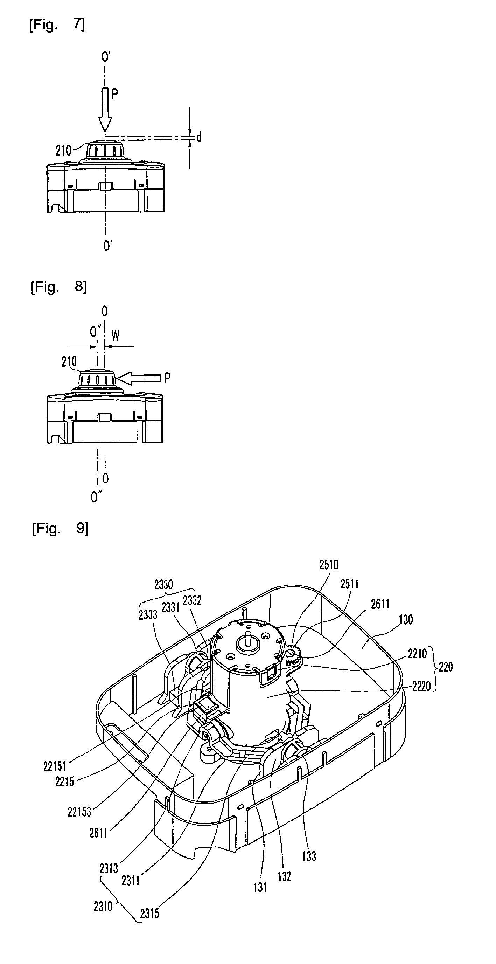

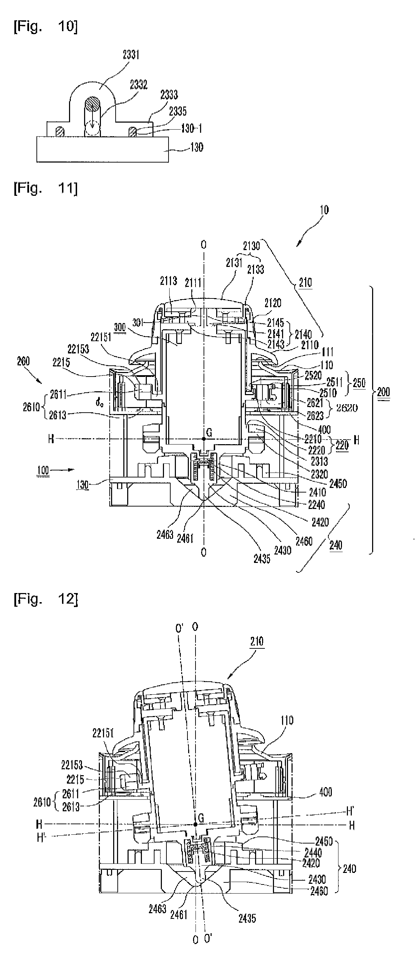

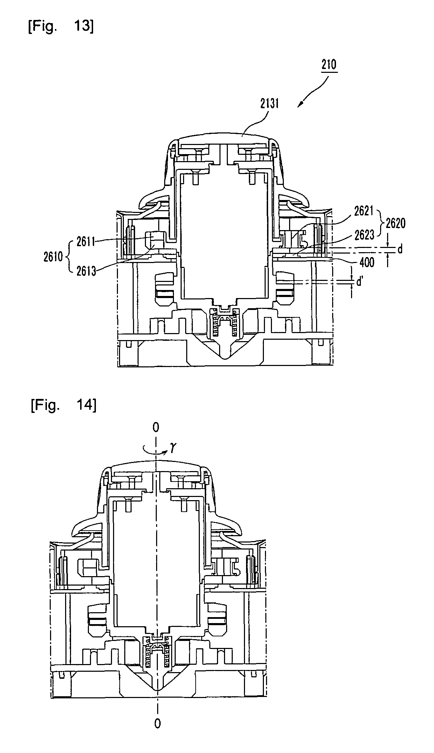

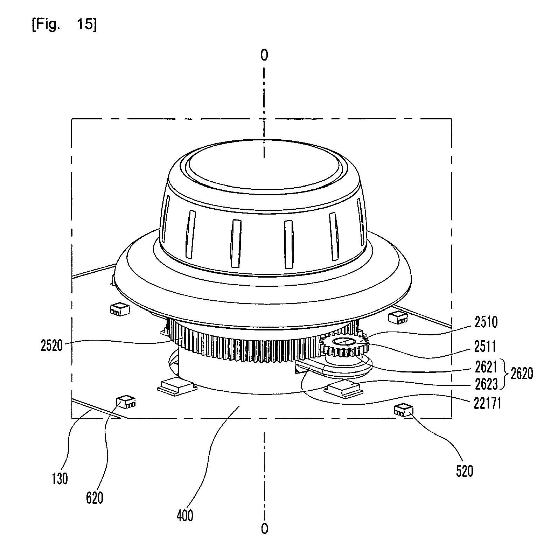

**FIG. 1** is a schematic perspective view illustrating a combined switch module 1 according to one (first) embodiment of the present invention, FIG. 2 is a schematic perspective view illustrating a combined switch device 10 according to one embodiment of the present invention, FIG. 3 is a schematic exploded perspective view illustrating a combined switch device 10 according to one embodiment of the present invention, FIG. 4 is a schematic cross-sectional perspective view illustrating a combined switch device 10 according to one embodiment of the present invention, FIGs. 5 to 8 are schematic views illustrating the operational state of a combined switch device 10 according to one embodiment of the present invention, FIG. 9 is a schematic partial perspective view illustrating a partial element of a combined switch device 10 according to one embodiment of the present invention, FIG. 10 is a schematic partial cross-sectional perspective view illustrating a partial element of a combined switch device 10 according to one embodiment of the present invention, FIG. 11 is a schematic cross-sectional view illustrating a normal state in which an external force is not applied to a combined switch device 10 according to one embodiment of the present invention, FIG. 12 is a schematic cross-sectional view illustrating an operational state in which a combined switch device 10 according to one embodiment of the present invention is tilt, FIG. 13 is a schematic cross-sectional view illustrating a push enter operational state of a combined switch device 10 according to one embodiment of the present invention, FIG. 14 is a schematic cross-sectional view illustrating a rotation operational state of a combined switch device 10 according to one embodiment of the present invention, and FIG. 15 is a schematic partial perspective view illustrating an operational state of switch knob rotary unit of a combined switch device 10 according to one embodiment of the present invention.

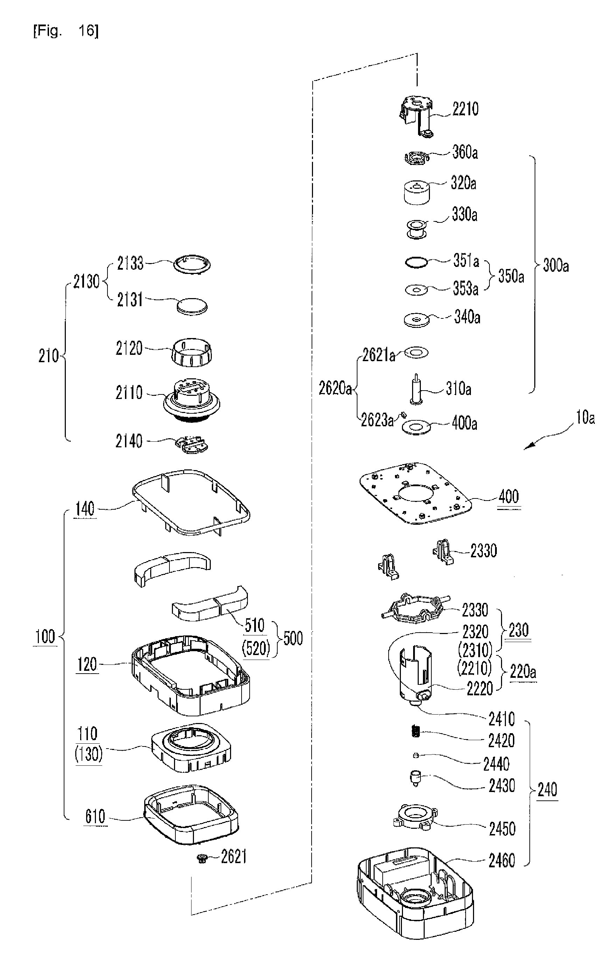

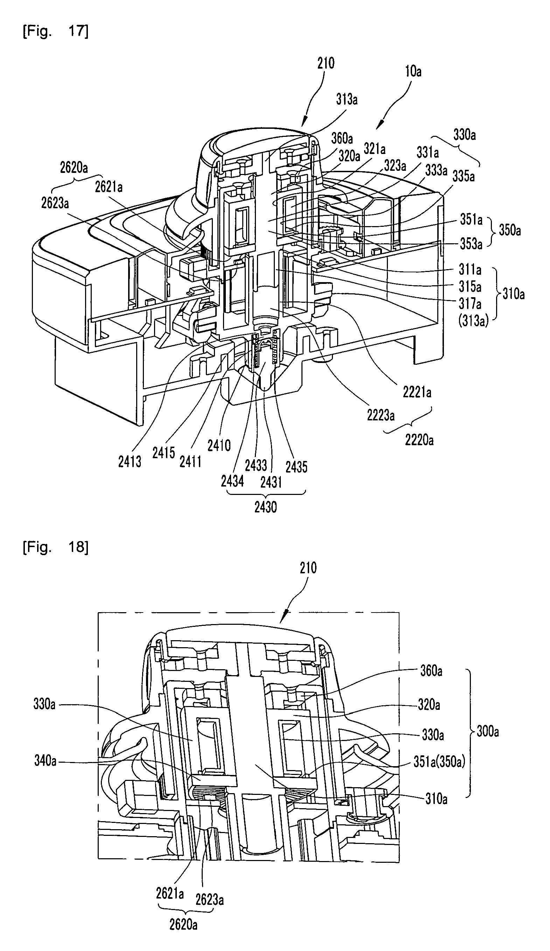

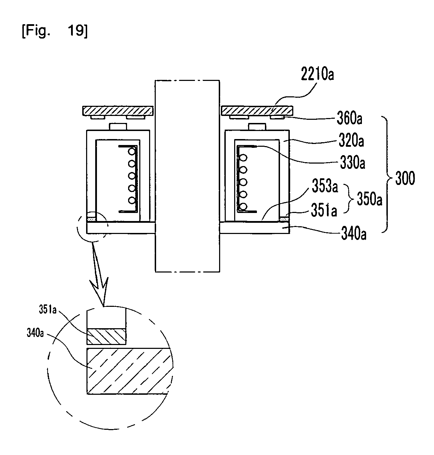

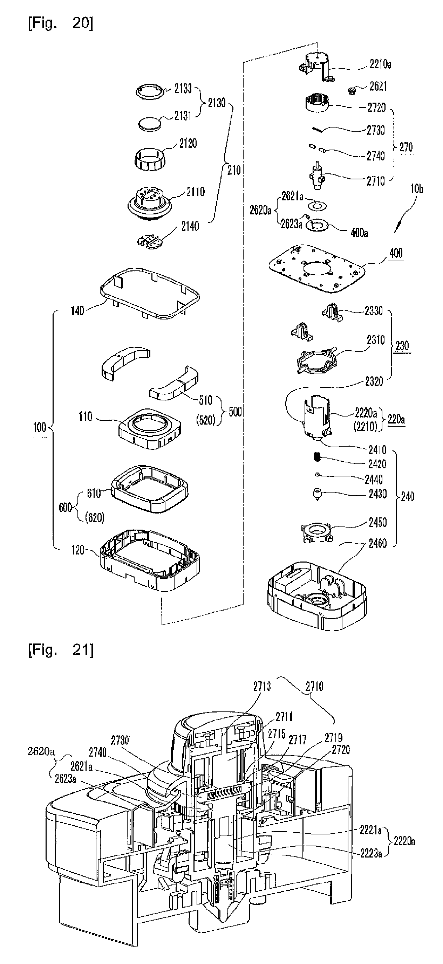

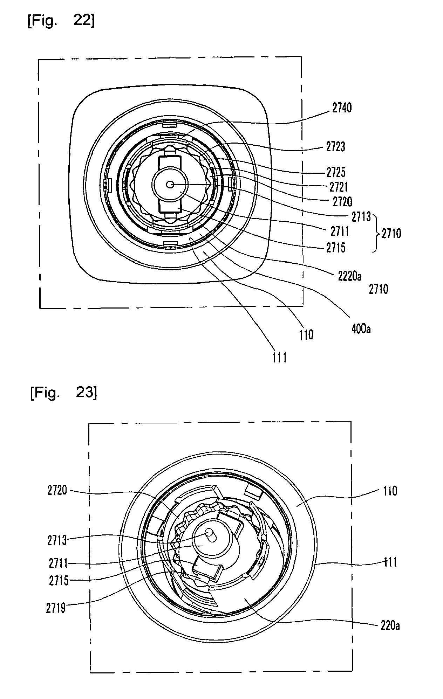

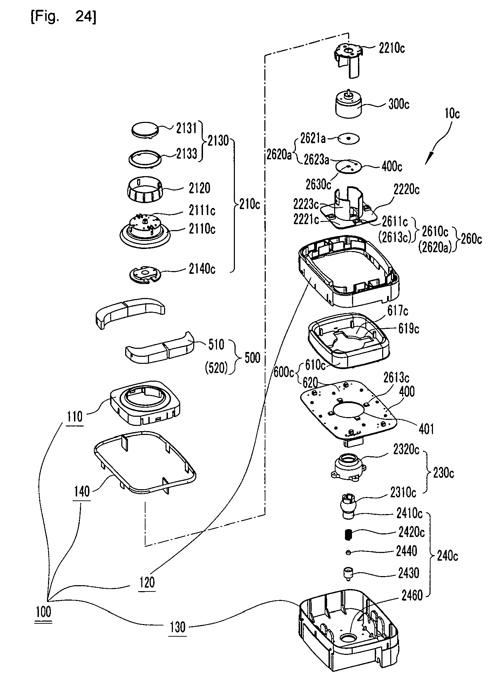

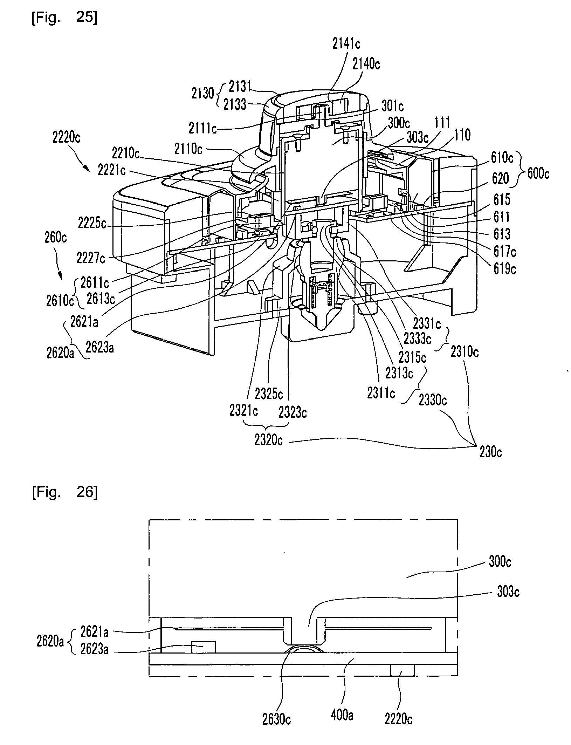

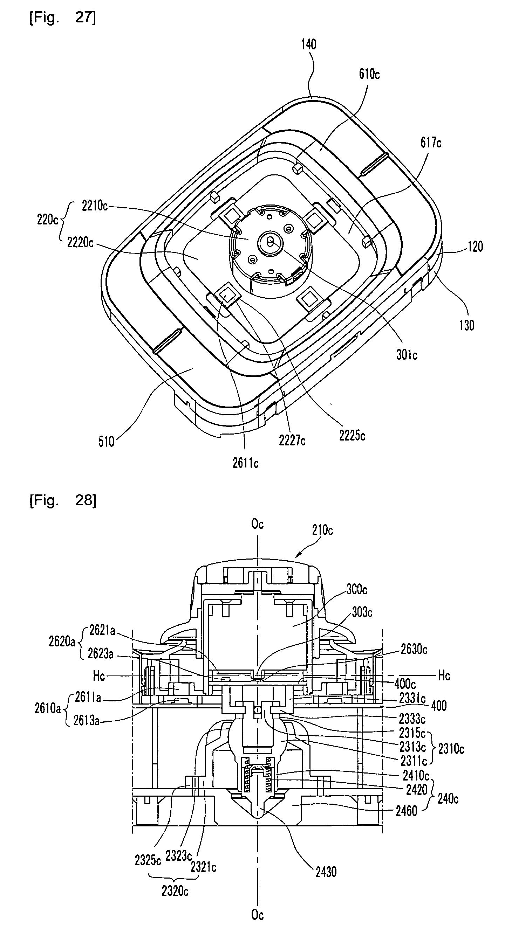

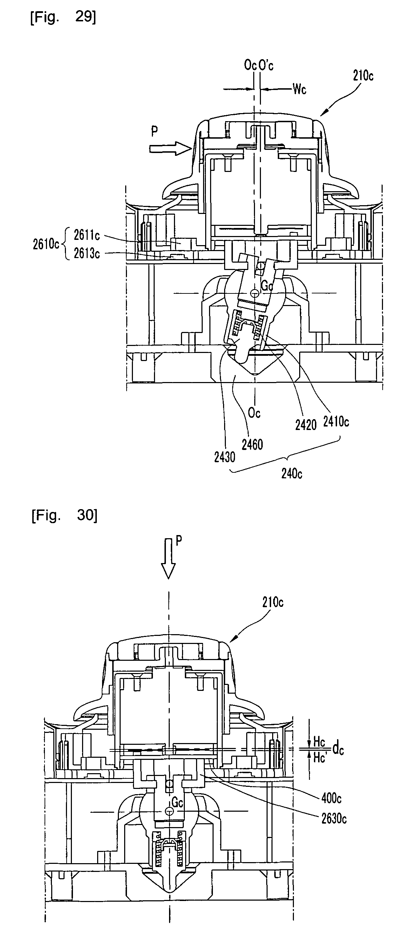

In addition, FIG. 16 is a schematic exploded perspective view illustrating a combined switch device 10a according to another (second) embodiment of the present invention, FIG. 17 is a schematic cross-sectional perspective view illustrating a combined switch device 10a according to another embodiment of the present invention, FIG. 18 is a schematic partial cross-sectional perspective view illustrating a combined switch device according to another embodiment of the present invention, FIG. 19 is a schematic partial cross-sectional view illustrating a haptic actuator 300 of a combined switch device 10a according to another embodiment of the present invention, FIG. 20 is a schematic exploded perspective view illustrating a combined switch device 10b according to still another (third) embodiment of the present invention, FIG. 21 is a schematic cross-sectional perspective view illustrating a combined switch device 10b according to still another embodiment of the present invention, FIGs. 22 and 23 are schematic partial top plan view and partial perspective view illstrating a switch detent unit 270 of a combined switch device 10b according to still another embodiment of the present invention, FIG. 24 is a schematic exploded perspective view illustrating a combined switch device 10c according to yet another (fourth) embodiment of the present invention, FIG. 25 is a schematic cross-sectional perspective view illustrating a combined switch device 10c according to yet another embodiment of the present invention, FIG. 26 is a schematic partial cross-sectional view illustrating a combined switch device 10c according to yet another embodiment of the present invention, FIG. 27 is a schematic partial perspective view illustrating a combined switch device 10c according to yet another embodiment of the present invention, FIG. 28 is a schematic cross-sectional view illustrating a normal state in which an external force is not applied to a combined switch device 10c according to yet another embodiment of the present invention, FIG. 29 is a schematic cross-sectional view illustrating a sliding movement of a switch knob of a combined switch device 10c according to yet another embodiment of the present invention, and FIG. 30 is a schematic cross-sectional view illustrating a push enter operational state of a combined switch device 10c according to yet another embodiment of the present invention.

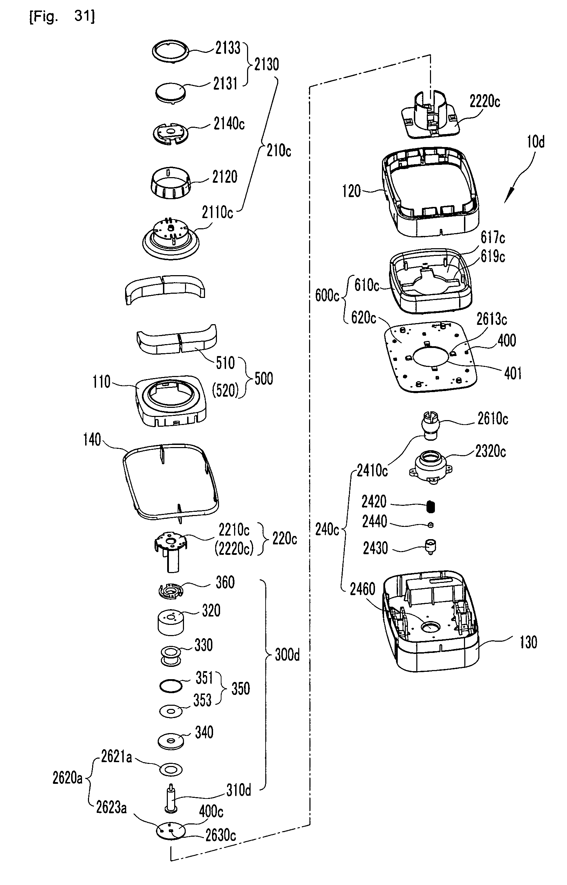

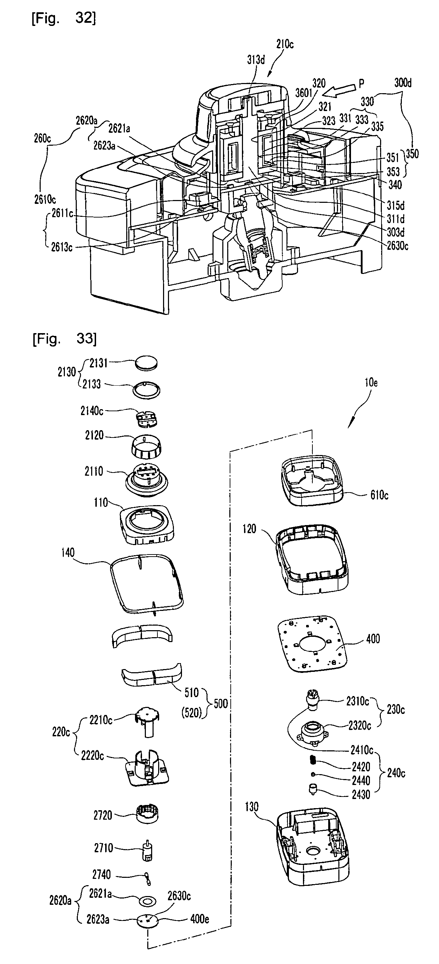

Further, FIG. 31 is a schematic exploded perspective view illustrating a combined switch device 10d according to a further (fifth) embodiment of the present invention, and FIG. 32 is a schematic cross-sectional perspective view illustrating a combined switch device 10d according to a further another embodiment of the present invention.

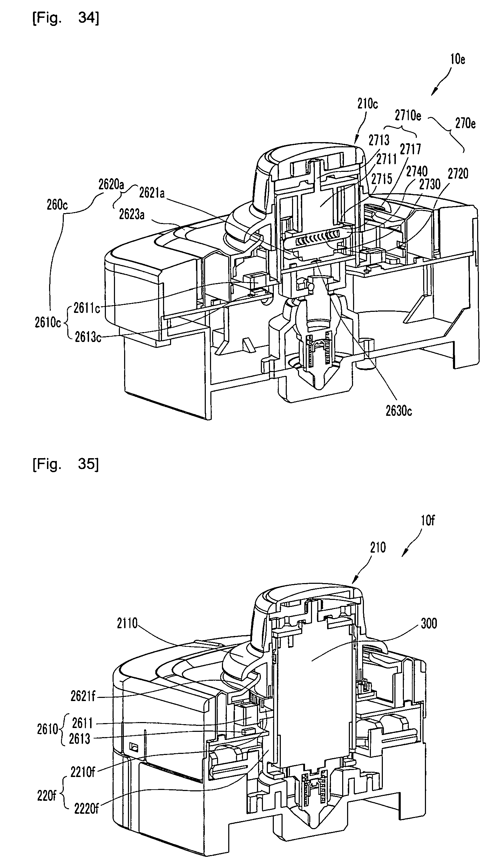

Moreover, FIG. 33 is a schematic exploded perspective view illustrating a combined switch device 10e according to a still further (sixth) embodiment of the present invention, and FIG. 34 is a schematic cross-sectional perspective view illustrating a combined switch device 10e according to a still further embodiment of the present invention.

The combined switch device 10 according to one embodiment of the present invention can constitute a combined switch module 1 mounted at a module housing 2 so as to be mountable at a center fascia or a dashboard of a vehicle (not shown) as shown in FIG. 1. As shown in FIG. 2, the combined switch device 10 may constitute an independent structure by itself without a separate module housing 2. The combined switch device 10 includes a housing 100, a switch unit 200, and a printed circuit board 400. The switch unit 200 includes a switch knob 210, a switch supporting unit 230 and 240, and a switch 260. The printed circuit board 400 is disposed in the housing 100. The switch 260 can establish an electrical connection with an external electrical device such as a control unit (not shown) or the like through the printed circuit board 400.

As shown in FIGs. 5 to 8, the combined switch device 10 according to one embodiment of the present invention is converted from a normal state of FIG. 5 in which no external force is applied to a switch knob to an operated state of FIG. 6 in which a predetermined external force P is applied. In other words, when the external force P is applied to the switch knob from a side of the switch knob, the switch knob 210 performs a tilting movement in such a fashion that the central axis O-O and an axial line O'-O' intersect each other while forming an angle of θwith respect to a center G. In addition, as shown in FIG. 7, when the external force P is applied to the switch knob 210 in the direction of the central axis O-O, the switch knob 210 performs an enter operation so that the switch knob is displaced vertically by a distance "d" denoted in FIG. 7 in the longitudinal direction of the central axis O-O. As shown in FIG. 8, when the external force P is applied to the switch knob 210 in a direction perpendicular to that of the central axis O-O in such a fasion as to prevent the switch knob 210 from being tilted, the switch knob 210 can perform is horizontally displaced by a distance "w" denoted in FIG. 8 in the transverse direction of the central axis O-O through a horizontal sliding movement as the central axis O-O is moved to an axial line O"-O".

The housing 100 of the combined switch device 10 includes a housing cover 110, a housing body 120, a housing base 130, and a housing strip 140. The elements of the housing 100 are engaged with each other to define a housing internal space for accommodating other elements therein. The housing cover 110 is disposed in the proximity of the center on a plane perpendicular to a rotating axis of the switch knob 210. The housing cover 110 includes a cover through-hole 111 formed therein so that it can take a structure in which the switch knob 210, a switch driving body 220 and the like which will be described later pass through the housing cover 110 through the cover through-hole 111 such that they are positioned at one ends thereof at the outside of the housing cover 110 and at the other ends thereof at the inside of the housing cover 110.

In this embodiment, the housing strip 140 is disposed on the outer circumference of the housing cover 110 so as to be spaced apart from the housing cover 110. That is, as shown in FIG. 4, disposed between the housing strip 140 and the housing cover 110 is a light guide 610, which will be described later, and the housing strip 140 has a structure in which it is connected with the housing cover 110 via the light guide 610. Various design modifications can be made within a range of defining the inner space of the housing through the connection between the housing cover and the housing strip. The housing strip 140 includes a housing strip frame 141 and a housing strip bridge 143. The housing strip frame 141 has a generally quadrangular shape, and the housing strip bridge 143 has a structure in which it extends inwardly from the housing strip frame 141. The housing strip bridge 143 can minimize a gap between button knobs of a button switch and prevent any interference from occurring upon the operation.

The housing body 120 is disposed at a lower end of the housing strip 140 in such a fashion as to be located in the outskirts of the housing cover 110. The housing body 120 is engaged with the housing base 130 to form another constituent element.

The housing base 130 is disposed at a lower end of the housing body 120 to define an inner space of the housing 100 together with the housing body 120. A base seating part 135 is disposed on the housing base 130 and a printed circuit board 400 which will be described later is disposed on the base seating part 135. The printed circuit board 400 is supported from the top by the housing strip 140 and the light guide 610 so that a stable arrangement structure can be implemented in the inner space of the housing 100. Although clearly not shown herein, a base connector (not shown) is disposed at a lower end of the housing base 130, and the printed circuit board 400 and /or a sub printed circuit board 400a which will be described later can establish an electrical connection with the external electrical device through the base connector (not shown).

The switch unit 200 includes a switch knob 210, a switch driving body 220, a switch supporting unit 230 and 240, and a switch 260. The switch 260 is driven through the operation of the switch knob 210 manipulated by a user. A change in an electrical signal generated from the switch 260 can be transferred to the external electrical device via the printed circuit board 400 and the base connector (not shown). The switch knob 210 is disposed on a top of the housing 100, more specifically, the housing cover 110. At least a part of the switch knob 210 can be disposed so as to be exposed to the inner space of the housing 100 while passing through the cover through-hole 111 formed in the housing cover 110. The switch knob 210 includes a knob body 2110, a knob grip 2120, a knob cover 2130, and a knob flywheel 2140. The knob body 2110 includes a knob body main part 2113 and a knob body cover part 2115. The knob body cover part 2115 is formed so as to extend outwardly from the outer circumference of the knob body main part 2113. Thus, when the knob body main part 2113 is rotated about an axial line O-O acting as a central axis, the knob body cover part 2115 is also rotated together with the knob body main part 2113. The knob body cover part 2115 has a diameter larger than that of the cover through-hole 111 of the housing cover 110 so that foreign substances can be prevented from being introduced into the housing 100. A knob body flywheel mounting part 2111 is formed on a top of the knob body main part 2113 so that the knob flywheel 2140, which will be described later, can be disposed to be oriented toward the top while passing through the knob body flywheel mounting part 2111. The knob grip 2120 is disposed at the outside of the knob body main part 2113, and has a plurality of grooves formed on the outer circumferential surface thereof so that a grip feeling of a user can be improved and a slip can be prevented upon the manipulation thereof. The knob grip 2120 has a structure in which it is opened at both ends thereof. A top of the knob grip- 2120 is in close contact with the knob cover which will be described later and a bottom of the knob grip 2120 is in close contact with the knob body main part 2113.

The knob cover 2130 includes a knob cover body 2131 and a knob cover strip 2133. The knob cover body 2131 is disposed on a top of the knob body main part 2113 to close one end of the knob grip 2120. The knob cover strip 2133 is disposed at the outer circumference of the knob cover body 2131. The knob cover strip 2133 includes a knob cover strip mounting part 2134 protrudingly formed at the inside thereof. The knob body main part 2113 includes a knob cover strip mounting counterpart 2114 formed at the top thereof to correspond the knob cover strip mounting part 2134, so that the knob cover strip mounting part 2134 is inserted into the knob cover strip mounting counterpart 2114 to allow the knob cover strip 2133 to be prevented from being separated from the knob body 2110.

The knob flywheel 2140 is disposed at a lower end of the knob cover body 2131 in such a fashion as to be positioned at the center of the switch knob 210. The knob flywheel 2140 is constructed as a mass body made of a material having a high specific gravity so that a predetermined inertia can be applied to the switch knob 210 to improve a manipulation feeling of the user. The knob flywheel 2140 includes a knob flywheel body 2141 and a knob flywheel plate 2143. The knob flywheel plate 2143 may be configured to have a structure in which it integrally extends outwardly from the outer circumference of the knob flywheel body 2141. The knob flywheel body 2141 has a structure in which it is disposed such that a top thereof passes through the knob body flywheel mounting part 2111 formed on the top of the knob body main part 2113 to cause the knob flywheel plate 2143 (← 2113) to be positioned at the inside of the knob body main part 2113. The knob flywheel body 2141 has a through-hole 2145 formed at the center thereof and has a structure in which a central axis (i.e., a haptic actuator shaft) of a haptic actuator which will be described later or a detent body passes through the through-hole 2145. Through this structure, the switch knob 210 can perform a relative rotation movement relative to the housing, more specifically the housing cover 110 and the switch driving body 220, which will be described.

The switch driving body 220 includes a top part 2210 and a bottom part 2220. The top part 2210 and the bottom part 2220 are engaged with each other to define the inner space of the switch driving body 220. The haptic actuator, which will be described later, and the like may be disposed in the inner space defined by the top part 2210 and the bottom part 2220. The switch driving body 220 can perform a tilting or sliding movement by means of a force transferred to the switch knob 210. The top part 2210 has a shaft through-hole 2211 formed therein so that an end of the shaft of the haptic actuator 300 or the detent body can pass through the shaft through-hole 2211 so as to be connected with the switch knob 210.

The switch supporting unit 230 and 240 supports the switch driving body 220 with respect to the housing 100. The switch driving body 220 and the switch knob 210 can perform a stable tilting or sliding movement by the switch supporting unit 230 and 240 with respect to the housing 100. The switch supporting unit includes a switch driving body-directional support 230 and a switch driving body-elastic support 240. The switch driving body-directional support 230 supports the switch driving body to enable the switch knob 210 to be moved on the plane that is vertical to a rotating axis line O-O of the switch knob 210. In addition, the switch driving body-elastic support 240 elastically supports the movement of the switch knob 210 in the axial direction of the rotating axis line O-O of the switch knob 210.

The switch driving body-directional support 230 includes a directional support fixing part 2330, a directional support body 2320, and a directional support frame 2310. The directional support fixing part 2330 is fixedly disposed in the housing 100 and the directional support frame 2310 is rotatably mounted to the directional support fixing part 2330. In addition, the directional support body 2320 is disposed at the outside of the switch driving body 220 and is mounted to the directional support frame 2310 so as to rotated about an axis perpendicular to a rotating axis of the directional support frame 2310 relative to the directional support fixing part 2330.

More specifically, the directional support frame 2310 includes a frame main part 2311, a frame body mounting part 2313, and a frame fixing and mounting part 2315. The frame main part 2311 has a generally quadrangular shape. The frame body mounting part 2313 is formed in pair on the opposing sides of the frame main part 2311 in such a fashion as to have a grooved structure capable of accommodating the directional support body 2320 which will be described later. That is, the frame body mounting part 2313 has a grooved structure formed along the line B-B. The frame body mounting part 2313takes a structure in which it is opened at a bottom thereof and is closed at a top thereof. In addition, the frame body mounting part 2313 has a length larger than a diameter of the directional support body 2320 in the direction of the axial line O-O so that the frame body mounting part 2313 of the grooved structure accommodates the directional support body 2320. In this case, the frame body mounting part 2313 may take a structure in which the directional support body 2320 is restricted in movement in the direction of the line A-A when viewed on the plane perpendicular to the line B-B and is allowed in movement in the direction of the line O-O to implement a connection structrure that is stable for the vertical displacement of the switch driving body 220.

The frame fixing and mounting part 2315 has a structure in which it extends in pair from the frame main part 2311 along the line A-A. The frame fixing and mounting part 2315 is connected with the directional support fixing part 2330 to restrict the movement of the directional support frame 2310 with respect to the housing so that the directional support frame 2310 can be prevented from being separated and escaping from the housing.

The directional support fixing part 2330 is formed in an inverse U-shape and has a structure of being fixed to the housing base 130. As shown in FIGs. 9 and 10, the directional support fixing part 2330 includes a fixing main portion 2331 and a fixing bridge 2333. The fixing main portion 2331 has a U-shape and the fixing bridge 2333 extends at an opened end of the fixing main portion 2331. The U-shaped fixing main portion 2331 has a groove 2332d formed therein. A pair of base fixing parts 131 is disposed on one side of the housing base 130 in such a fashion as to be located at the mounting position of each directional support fixing part 2330. The pair of base fixing parts 131 is disposed spaced apart from each other to define a space therebetween so that each directional support fixing part 2330 is interposed in the space 132. A bridge mounting part 2335 is formed at the fixing bridge 2333 of the directional support fixing part 2330, and is fixed to the housing base 130 through a connecting part 130-1. In addition, each base fixing part 131 has a groove 133 formed thereon so that the directional support body 2320 can pass through the groove 133 to allow for connection with the directional support fixing part 2330 interposed between the pair of base fixing parts. In addition, as shown in FIG. 10, the groove 2332 of the fixing main portion 2331 has a predetermined length to allow for the stable vertical movement of the directional support body 2320 and restrict the horizontal movement of the directional support body 2320.

The switch driving body 220 performs its rotation about the line A-A and the line B-B through the switch driving body-directional support 230 of a universal join structure so that the switch driving body 220 can conduct the tilting movement/the sliding movement having a given degree of freedom.

Further, the switch supporting unit includes the switch driving body-elastic support 240, which elastically supports its movement in the direction of the rotating axis, i.e., the axial line O-O of the switch knob 210. The switch driving body-elastic support 240 includes a support holder 2410, a support elastic part 2420, a support body 2430, and a support body counterpart 2460. The support holder 2410 is disposed beneath the switch driving body 220 and the support body 2430 is disposed at the support holder 2410 such that the support body can perform its sliding movement. The support elastic part 2420 is in close contact at one end thereof with the support holder 2410 and at the other end thereof with the support body 2430, and applies an elastic force between the support holder 2410 and the support body 2430. The support body counterpart 2460 is disposed at the housing 100, more specifically the housing base 130 to correspond to an end of the support body 2430 to allow the support body 2430 to perform the tilting movement.

The support holder 2410 is integrally formed at the bottom of the switch driving body 220, and may have a structure in which it is separately mounted at the bottom of the switch driving body 220. The support holder 2410 is formed in a cylindrical shape which it is opened at a bottom thereof has a hole 2411 formed therein. The support body 2430 is inserted into the hole 2411 in a slidable manner. An elastic mounting part 2413 is formed at the inner side of the hole 2411 of the support holder 2410 so that one end of the support elastic part 2420 is stably seated in the elastic mounting part 2413. The elastic mounting part 2413 has a support holder enter counterpart 2415 formed at the center thereof so as to protrude downwardly.

The support body 2430 is inserted into the hole 2411 of the support holder 2410. The support body 2430 also has a structure in which it is opened at one end thereof. The one end of the support body 2430 is oriented toward the hole 2411. The support body 2430 also has an elastic mounting part 2431 formed therein so that the other end of the support elastic part 2420 is stably seated in the elastic mounting part 2431. A support body enter counterpart 2433 is disposed at the inner center of the elastic mounting part 2431 to correspond to the support holder enter counterpart 2415. A support body load part 2435 is disposed at the other end of the support body 2430, i.e., an opposing end of the support holder 2410, and preferably has a structure in which its end is rounded so that the tilting or sliding movement of the switch knob 210 can be performed smoothly.

The support elastic part 2420 is disposed between the support holder 2410 and the support body 2430. In this embodiment, the support elastic part 2420 is configured as a coil spring but its various modifications may be made within a range of providing an axial elastic force. Both ends of the support elastic part 2420 are seated in the elastic mounting part 2413 and the elastic mounting part 2431 so that the support holder 2410 and the support body 2430 are prevented from being displaced to achieve a smooth compression and returning movement upon the relative sliding movement between the support holder 2410 and the support body 2430.

The support enter part 2440 may further be disposed between the support holder 2410 and the support body 2430. The support enter part 2440 is formed to have a dome structure which can elastically deformed. That is, the support enter part 2440 is mounted an opened portion thereof at the support body enter counterpart 2433 and is disposed at a closed end thereof toward the support holder enter counterpart 2415. Thus, when an external force is applied to the switch knob 210 by a user in an axial direction, i.e., in the direction of an axial line O-O, the support holder enter counterpart 2415 is brought into close contact with the closed end of the support enter part 2440 and a clicking feeling is transferred to the switch knob 210 through the support body enter counterpart 2433 via the switch driving body 220 upon the elastic deformation of the support enter part 2440 in terms of the property of its dome structure to provide an enter operation feeling to the user. Then, when the external force is removed, the support enter part 2440 returns to its original position or shape by its elastic restoring force so that the switch knob 210 can return to a pre-compression state for the enter operation.

The support body counterpart 2460 is mounted at a corresponding position of the support body load part 2435, i.e., on one surface of the housing 100, more specifically the housing base 130. The support body counterpart 2460 includes an apex end 2461 and a sloping surface 2463. The sloping surface 2463 form a conical sloping surface on both sides of the apex end 2461 so that the support body counterpart 2460 can maintain the mutual operation state with the support body load part 2435. As shown in FIG. 11, when no external force is applied to a side of the switch knob 210, the support body load part 2435 is in close contact with the apex end 2461 and is elastically supported by the elastic force of the support elastic part 2420 to form a stable state. Thereafter, as shown in FIG. 12, when any external force is applied to a side of the switch knob 210 by a user, it is transferred to the support body load part 2435 from the switch knob 210 via the switch driving body 220. At this time, the support elastic part 2420 is elastically compressed and deformed, and the support body 2430 is displaceably inserted into the hole 2411 of the support holder 2410 through the relative sliding movement between the support body 2430 and the support holder 2410 so that the support body load part 2435 formed at a lower end of the support body 2430 forms an unstable state in which it is brought into close contact with the sloping surface 2463 of the support body counterpart. The central axis of the switch knob 210 is changed in angle by θformed by the axial line O-O and the axial line O'-O' based on the central point G so that the switch knob 210 performs its tilting movement. Then, when the external force is removed, the support elastic part 2420 returns to its original state by the elastic restoring force stored in the support elastic part 2420 so that the support body load part 2435 is displaced to the apex end 2461 of the support body counterpart while maintaining the contact with the sloping surface 2463 of the support body counterpart 2460, resulting in conversion into a stable state. Ultimately, the support body 2430, the switch supporting unit 230 and the switch knob 210 returs to their original positions in which the central axis is arranged coaxially with the axial line O-O.

The switch unit 200 includes a switch 260. The switch 260 includes a directional switch 2610 and a rotary switch 2620. The directional switch 2610 is disposed on the switch driving body 220 and the printed circuit board 400 and is driven by a motion performed on a plane that is vertical to the rotating axial line O-O of the switch knob 210. The rotary switch 2620 is driven by the central rotation of the rotating axis of the switch knob 210. That is, the directional movement occurring by the tilting or sliding movement of the switch knob 210 drives the directional switch 2610, and the rotary movement occurring along a rotation central axis line O-O of the switch knob 210 drives the rotary switch 2620.

The directional switch 2610 may be implemented in various forms. In this embodiment, the directional switch 2610 is implemented as a magnetic sensor type. The directional switch 2610 includes a directional switch magnet 2611 and a directional switch sensor 2613. The directional switch magnet 2611 is disposed at the outside of the switch driving body 220 and the directional switch sensor 2613 is disposed one side of the printed circuit board 400 to correspond to the directional switch magnet 2611 and is driven by the tilting movement of the switch knob 210. More specifically, a switch mounting part 2213 is disposed on the outer circumference of a lower end of the top part 2210 of the switch driving body 220. The switch mounting part 2213 includes a directional switch mounting part 2215 and a rotary switch mounting part 2217. Among these, the directional switch mounting part 2215 is disposed on the outer circumference of a lower end of the top part 2210 of the switch driving body 220. The directional switch mounting part 2215 includes a directional switch mounting extension part 22151 and a directional switch mounting hole 22153. The directional switch mounting extension part 22151 extends radially outwardly from the outer circumference of the lower end of the top part 2210. The directional switch mounting hole 22153 is formed at an ende side of the directional switch mounting extension part 22151. The directional switch mounting hole 22153 has a through structure so that the directional switch magnet 2611 is insertedly mounted to the directional switch mounting hole 22153. The directional switch sensor 2613 is disposed one side of the printed circuit board 400 to correspond to the directional switch magnet 2611. The directional switch magnet 2611 is supported by the switch driving body-directional support 230 together with the switch driving body 220 driven by the switch knob 210. The directional switch magnet 2611 is displaced integrally with the switch driving body 220 upon the directional movement so that the displacement and the tilting movement can be detected by the directional switch sensor 2613. In this embodiment, as shown in FIG. 4, the directional switch magnet 2611 has a top and bottom bipolar arrangement structure in which directional switch magnet 2611 has an N-pole magnet piece arranged at a top thereof and an S-pole magnet piece arranged at a bottom thereof. The directional switch sensor 2613 is implemented as a magnetic sensor of a magnetic resistance (MR) type. The directional switch sensor 2613 can detect the tilting angle of the directional switch magnet 2611 through a magnetic field generated by the directional switch magnet 2611 having the top and bottom bipolar arrangement structure. Although it has been shown in the embodiment shown in FIG. 4 that each of the directional switch magnet 2611 and the directional switch sensor 2613 is provided in a singular number, the directional switch magnet 2611 and the directional switch sensor 2613 may be modified in various manners, such as being provided in plural pairs depending on a design specification.

The rotary switch 2620 serves to detect the rotational movement of the switch knob 210. In this embodiment, the rotary switch 2620 includes a rotary switch magnet 2621 and a rotary switch sensor 2623. The switch unit 200 may further include a separate constituent element so that the rotary switch magnet 2621 and the rotary switch sensor 2623 receive a rotational force of the switch knob 210. The switch unit 200 according to the present invention further includes a switch knob rotary unit 250. The switch knob rotary unit 250 includes a rotary switch rotation roller 2510 and a rotary switch rotation roller counterpart 2520. The rotary switch rotation roller 2510 is rotatably disposed on the outer circumference of the switch driving body 220, and the rotary switch rotation roller counterpart 2520 is disposed at a lower end of the swich knob 210 and is engaged wth the rotary switch rotation roller 2510 in such a fashion as to be rotatable relative to the rotary switch rotation roller 2510. More specifically, as shown in FIG. 14, when the switch knob 210 is rotated by an angle y, the rotary switch rotation roller counterpart 2520 provided on the outer circumference of the lower end of the switch knob 210 disposed at the bottom of the housing cover 110 is rotated together with the switch knob 210. The rotary switch rotation roller counterpart 2520 is formed in a gear shape. The rotary switch rotation roller 2510 is disposed at a corresponding position of the rotary switch rotation roller counterpart 2520 so that it is rotatably meshed with the rotary switch rotation roller counterpart 2520. In this case, the rotary switch rotation roller 2510 is rotatably disposed at the rotary switch mounting part 2217 of the switch driving body 220. The rotation ratio between the switch knob 210 and the rotary switch rotation roller 2510 can be adjusted depending on the number of gear teeth of the rotary switch rotation roller counterpart 2520 and the rotary switch rotation roller 2510.

As shown in FIG. 15, the rotary switch mounting part 2217 includes a rotary switch mounting extension part 22171 extending outwardly from the outer circumference of the top part 2210. The rotary switch mounting extension part 22171 is disposed radially from the center of the top part 2210. The rotary switch mounting extension part 22171 has a through-hole 22173 formed at the center thereof so that the rotary switch magnet 2621 is seated in the through-hole 22173. When the switch knob 210 is rotated, the rotary switch rotation roller counterpart 2520 formed at the lower end of the switch knob 210 rotates the rotary switch rotation roller 2510 meshed therewith. At this time, the rotary switch rotation roller 2510 is rotatably positioned at the through-hole 22173 of the rotary switch mounting extension part 22171, and a rotary switch sensor 2623 detects a change in the magnetic filed depending on the rotation state of the rotary switch magnet 2621 insertedly mounted to the through-hole 22173 and transfer the detected change to a control unit (not shown) to perform a certain control process.

In this case, as shown in FIG. 4, the rotary switch magnet 2621 has a vertical (left and right) polarization structure, for example, a cylindrical structure employing an axis parallel to the axial line O-O as a central axis, i.e., a certain cylindrical structure in which each of an N pole and S pole is formed in a semicircular shape to form a certain cylindrical shape. The rotary switch magnet 2621 forms a magnetic field corresponding to the vertical (left and right) polarization structure through the vertical (left and right) polarization structure, and the rotary switch sensor 2623 transfers a change in an electrical signal depending on a change in the magnetic filed generated by the rotation of the rotary switch magnet 2621 to the control unit (not shown), which in turn transmits a control signal to various operating units such as an air conditioning device to perform an operation according to a predetermined control signal selected by the user.

In addition, simultaneously, when the rotary switch magnet 2621 of the vertical (left and right) polarization structure is displaced vertically, the rotary switch sensor 2623 disposed at the position corresponding to the rotary switch magnet 2621 detects a change in the electrical signal depending on a change in the strength of the magnetic field produced from the rotary switch magnet 2621 and transfers the change in the electrical signal to the control unit (not shown) so that a certain operating unit can be controlled. As shown in FIG. 13, when the switch knob 210 is vertically compressed in the axial direction of the axial line O-O, the switch driving body 220 connected with the switch knob 210 is displaced by the elastic deformation due to the vertical sliding movement of the switch driving body-elastic support 240 to cause a vertical position variation "d" of the switch knob 210. Simultaneously, the rotary switch magnet 2621 disposed on the outer circumference of the switch driving body 220 is displaced and ultimately the rotary switch sensor 2623 detects a change in the strength of the magnetic field generated from the rotary switch magnet 2621 and is driven by the change of the strength of the magnetic field so that the control signal of the control unit transmitted to a certain operating unit can be sensed.

In the meantime, the combined switch device 10 according to the present invention may further include a constituent element that has a function of a manipulation panel actuated by the switch driving by a force applied by a user or a user manipulation or the generation of a variation signal, and that is configured to allow the user to haptically perceive a control signal or state provided to the combined switch device or a target operating unit to be controlled by the combined switch device. In other words, as shown in FIG. 4, the combined switch device 10 may further include a haptic actuator 300. The haptic actuator 300 has a structure in which it is disposed in the switch driving body 220 and is connected at one end thereof to the switch knob 210. The haptic actuator 300 may be constructed in various manners depending on a design specification. In the embodiment shown in FIG. 4, the combined switch device 10 includes a haptic actuator 300 of an electric motor type. The haptic actuator 300 of the electric motor type includes a haptic actuator shaft end of a haptic actuator shaft acting as a transmission shaft. The haptic actuator shaft end 301 is rotated in response to an electrical signal applied to the haptic actuator 300 through the printed circuit board 400. The haptic actuator shaft end 301 is connected to the switch knob 210 and is insertedly disposed in the through-hole 2145 of the knob flywheel body 2141. The haptic actuator shaft end 301 and the through-hole 2145 have a quadrangular shape in which they are engaged with in a press-fit manner or correspond to each other so that the relative rotational movement between the knob flywheel body 2141, ultimately the switch knob210 and the haptic actuator 300 can be prevented. A storage unit (not shown) stores preset data for controlling the operation of the haptic actuator and the control unit (not shown) establishes an electrical connection with the storage unit. Thus, when the user manipulates the switch knob 210, the electrical signals generated from the directional switch sensor 2613 and the rotary switch sensor 2623 of the directional switch 2610 and/or the rotary switch 2620 by the tilting/enter operation of the switch knob 210 is transferred to the control unit (not shown). The control unit generates a predetermined haptic actuator control signal, for example, a resistance force that is enough to feel a detent feeling or a resistance feeling of the haptic actuator shaft and acts in an direction opposite to the rotating direction of the switch knob or a rotating force that acts rapidly in the forward and reverse directions using the input signal generated by the driving of the switch knob 210 and the preset data stored in the storage unit so that the user can haptically perceive a detent feeling, a detent feeling, or a vibration feeling through the switch knob.

In the above embodiment, although the haptic actuator 300 is constructed in the electric motor type, it may be constructed in various manners within a range of enabling the user to make a haptic perception. As shown in FIG. 16, the combined switch device 10a may include a haptic actuator 300a of an electromagnet type. In FIG. 16, there is shown a schematic exploded perspective view of the combined switch device 10a. In this embodiment, the same elements as those described in the aforementioned embodiment are denoted by the same reference numerals, and thus the repeated description thereof will be omitted to avoid redundancy and the description of only different elements from those in the aforementioned embodiment will be made.

The haptic actuator 300a is substituted for the haptic actuator 300 of the electric motor type shown in FIG. 4. The haptic actuator 300a of the electromagnet type can also be connected with the printed circuit board 400 to establish an electrical connection with the control unit (not shown). The electromagnet type haptic actuator 300a includes a haptic actuator shaft 310a, a haptic actuator housing 320a, a haptic actuator bobbin 330a, and a haptic actuator disk 340a. The haptic actuator shaft 310a is rotatably disposed at the switch driving body. The switch driving body includes a shaft rotation support part 2221a disposed on the inner surface of a bottom part 2220a thereof so as to extend toward the switch knob 210. A shaft rotation support hollow portion 2223a is formed at the center of the shaft rotation support part 2221a so as to be oriented toward the switch knob 210.

The haptic actuator shaft 310a includes a shaft body 311a, a shaft rotation support part 317a, and a shaft stopper 315a. The shaft rotation support part 317a is rotatably inserted into the shaft rotation support hollow portion 2223a, and the shaft stopper 315a is brought into close contact with an end of the shaft rotation support part 2221a so that an excessive insertion of the haptic actuator shaft 310a into the shaft rotation support hollow portion 2223a is prevented and the haptic actuator shaft 310a can be rotated stably.

A shaft knob mounting part 313a is formed at the other end of the haptic actuator shaft 310a to as to be oriented toward the switch knob 210. The relative rotational movement between the switch knob210 and the haptic actuator 300 can be prevented through a quadrangular pre-fit structure in which the shaft knob mounting part 313a passes through the haptic actuator housing 320a and is engaged with the knob flywheel body through-hole 2145 in a press-fit manner or correspond to the knob flywheel body through-hole 2145

The haptic actuator housing 320a is disposed at the inside of the switch driving body 220a and is formed in a " 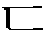 "-shape in which it is spaced apart from the central line O-O so that its cross-section is laid down. The haptic actuator housing 320a has a structure in which it is opened at one end thereof. The haptic actuator housing 320a has a through-hole 321a formed at the center thereof and a bobbin hole 323a formed therein. The bobbin hole 323a of the haptic actuator housing communicates with the outside through an opened one side. The haptic actuator shaft 310a passes through the shaft through-hole 321a of the haptic actuator housing and is engaged with the knob flywheel 2140 (←240) of the switch knob 210. In this embodiment, although the haptic actuator housing 320a is implemented by including Steel Nickel Chromium (SNC), this is merely one example and it may be constructed in various manners within a range of causing the magnetic interaction between the haptic actuator housing 320a and the haptic actuator disk which will be described later, by forming a ferromagnetic material and including a proper friction cofficient.

The haptic actuator bobbin 330a is inserted into the bobbin hole 323a of the haptic actuator housing and includes a bobbin body 331a and a bobbin plate 335a. The bobbin plate 335a is formed in the shape of a donut plate and is disposed at both ends of the hollow bobbin body 331a. The bobbin body through-hole 333a is formed at the center of the bobbin body 331a so that the bobbin plate 335a can be disposed in the haptic actuator housing 320a through the bobbin body through-hole 333a. Although not shown, a haptic actuator coil(not shown) is wound around the outer circumference of the bobbin body 331a and is connected with the printed circuit board 400 or the sub printed circuit board 400a which will be described later to establish an electrical connection with an electrical element such as the control unit.

The haptic actuator disk 340a is disposed at an opened end of the haptic actuator housing 320a in such a fasion that it is mounted to an end of the haptic actuator shaft 310a so as to be rotated together with the haptic actuator shaft 310a, ultimately the switch knob 210. The haptic actuator disk 340a can be in close contact with an end of the haptic actuator housing 320a. A haptic actuator medium 350a mayfurther be provided between the haptic actuator disk 340a and the haptic actuator housing 320a. The haptic actuator medium 350a may include a friction ring 351a and a disk washer 353a. The haptic actuator disk 340a may be brought into direct contact with an end of the haptic actuator housing 320a, but may be implemented in an indirect contact manner through a separate friction ring 351a in order to prevent an erroneous operation due to abrasion or the like. That is, as shown in FIGs. 17 and 19, the friction ring 351a is disposed at an end of the haptic actuator housing 320a, and the disk washer 353a is disposed on one surface of the haptic actuator disk 340a so as to be oriented toward the haptic actuator housing 3420a so that the rotation of the haptic actuator disk 340a, ultimately the switch knob 210 can be controlled smoothly.

The haptic actuator disk 340a is formed of a ferromagnetic material such as SNC so that it is attracted toward the haptic actuator housing 320a by an electric field generated in response to an electrical signal applied to the haptic actuator coil wound around the outer circumference of the haptic actuator bobbin 330a. Herein, the haptic actuator disk 340a employs SNC, but may be formed of various materials within a range of causing the electromagnetic interaction between the haptic actuator disk 340a and the haptic actuator housing.

An elastic member 360a is interposed between an end of the haptic actuator housing 320a and the inside of top part 2210 of the switch driving body so as to elastically support the haptic actuator housing 320a. In this embodiment, the haptic actuator elastic member 360a is formed as a spiral spring so that the elastic member 360a is in close contact at one end thereof with the inner surface of the top part 2210 and is in close contact at the othe end thereof with one surface of the haptic actuator housing 320a to provide a predetermined elastic supporting force between the top part 2210 and the haptic actuator housing 320a and alleviate a change in the impact caused by a rapid operation. Thus, the electrical signal applied to the haptic actuator 300 through the printed circuit board or the sub printed circuit board is transferred to the haptic actuator coil, which in turn generates a certain electric field in response to the electrical signal. In a normal state, a given gap is defined between the end of the haptic actuator housing 320a and the friction ring 351a to allow for the smooth rotation of the switch knob. Then, the haptic actuator disk 340a formed of a ferromagnetic material is attracted toward the haptic actuator housing 320a by the generated electric field so that the friction ring 351a and the haptic actuator disk 340a form the contact state by the induction of the electric field. As a result, the gap between the haptic actuator housing 320a and the friction ring 351a is removed to form the close contact state of the haptic actuator housing 320a and the friction ring 351a. This close contact state enables the rotation state of the switch knob 210 to be determined through the interaction with the electrical signal applied to the haptic actuator coil.

Meanwhile, a separate sub printed circuit board 400a may further be provided below the haptic actuator disk 340a so as to transfer the electrical signal applied to the haptic actuator coil or the like. The sub printed circuit board 400a is disposed at the inside of the top part 2210 and has a through-hole formed at the center thereof. The shaft rotation support part 2221a extending form the inside of the bottom part 2220a passes through the through-hole of the sub printed circuit board 400a.

In addition, the switch unit may include a rotary switch acting as a separate switch drive sensing means besides an element denoted by a reference numeral 2620. That is, the separate rotary switch 2620a includes a rotary switch encoder 2621a and a rotary switch sensor 2623a. The rotary switch encoder 2621a is rotated together with the switch knob 210 and the rotary switch sensor 2623a is disposed on one surface of the sub printed circuit board 400a to correspond to the rotary switch encoder 2621a. The rotary switch encoder 2621a is implemented as an encoder of a black and white alternating arrangement type as shown in FIG. 18. The rotary switch sensor 2623a is implemented as a photo sensor including a light emitting unit and a light receiving unit to detect intermittent light generated upon the rotation of the encoder of the black and white alternating arrangement type so that the rotation amount or rotation speed of the switch knob 210 can be detected.

As described above, the combined switch devices 10 and 10a according to the present invention perform the rotary/tilting or sliding/enter operation through the switch knob to enable a combined switching operation. The switch unit 200 may further include a separate button switch unit 500 according to the circumstances. As shown in FIGs. 3, 4, 16 and 17, the button switch unit 500 includes a button switch knob 510 and a button switch 520. The button switch knob 510 is actuatably disposed at the outside of a housing cover 110 in such a fashion as to be positioned between the housing cover 110 and the housing strip 140. The button switch 520 is implemented as a tact switch, and is fixedly mounted on one surface of the printed circuit board 400 to correspond to the button switch knob 510. Thus, when the user presses a certain button switch 520, the button switch 520 disposed on the printed circuit board 400 is pressurized and actuated to generate a predetermined electrical signal, which in turn is transferred to an external electrical device or the like via the printed circuit board 400 so that a predetermined control signal can be transferred to an operating unit which it is desired to control.

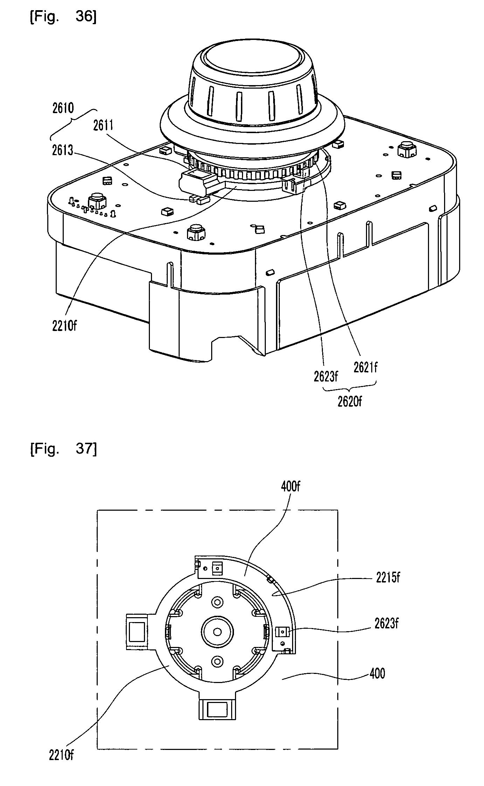

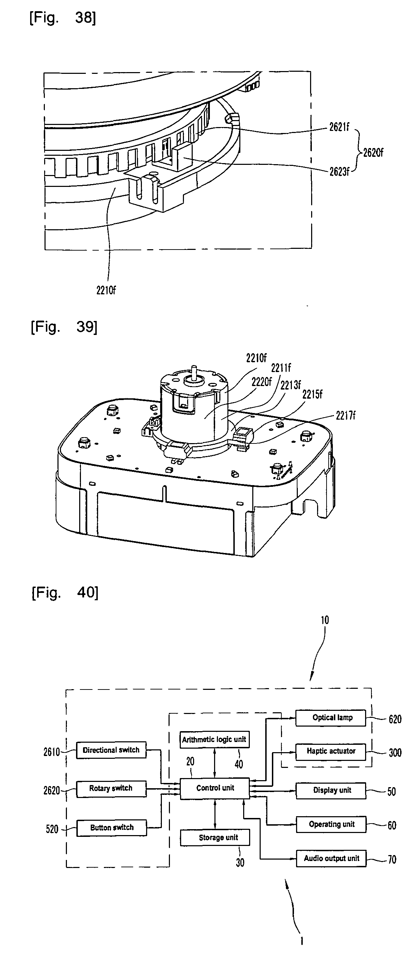

In addition, the switch unit may include a rotary switch of another type besides an element denoted by a reference numeral 2620. As shown in FIGs. 35 to 38, the switch knob 210 of a combined switch device 10f is connected with a switch driving body 220f amd the haptic switch 300 is disposed at the inside of the switch driving body 220f. The switch driving body 220f includes a top part 2210f and a bottom part 2220f. The switch unit includes a directional switch 2610 and a rotary switch 2620f. The directional switch 2610 includes a directional switch magnet 2611 and a directional switch sensor 2613 that are respectively disposed on the top part of the switch driving body and the printed circuit board in the same manner as that in the aforementioned embodiment. The rotary switch 2620f includes a rotary switch encoder 2621f and a rotary switch sensor 2623f. The rotary switch encoder 2621f is implemented as a slit type and is disposed at a lower end of the top part 2210f. The sub printed circuit board 400f is disposed at the lower end of the top part 2210f. The rotary switch sensor 2623f is disposed on one surface of the sub printed circuit board 400f. The rotary switch sensor 2623f is implemented as a photo sensor type, which includes a light receiving unit and a light emitting unit. Alternatively, the rotary switch sensor 2623f may have a structure in which a slit portion of the rotary switch encoder 2621f is moved between the light receiving unit and the light emitting unit to cause intermittence of certain light to occur so that the rotation state of the switch knob 210 can be detected ultimately.

In addition, the combined switch devices 10 and 10a according to the present invention may further include a light display unit(optical light indicating unit) 600 acting as an element that allow a user to visibly perceive a given operating state selected by the user. In this embodiment, the light display unit 600 includes a light guide 610 and an optical lamp 620. The light guide 610 is disposed between the housing 100, more specifically, the housing cover 110 and the housing strip 140 in such a fashion as to be positioned in the proximity of the outer circumference of the housing cover 11. The light guide 610 serves to uniformly deliver light emitted from the optical lamp 620 which will be described. The light guide 610 includes a plurality of protrusions 6132 formed on the inner surface thereof and the housing cover 110 has a plurality of protrusion counterparts 113 formed thereon. The protrusions 6132 of the light guide are engaged with the protrusion counterparts 113 of the housing cover so that the light guide and the housing cover are fixed in their positions. Thus, a change in the electrical signal generated from the switch 260 and the button switch 520 through the manipulation of the switch knob 210 and the button switch knob 510 by the user is transferred to the control unit via the printed circuit board 400. Then, the control unit controls the optical lamp 620 to be actuated based on a certain signal from the switch 260 and the button switch 520 using the preset data stored in the storage unit. The optical lamp 620 is composed of a plurality of lamps having various colors such as a thee-color LED of red, blue and green and/or a white color LED so that light having a certain color based on the control signal can be outputted. In addition, a predetermined visual signal is outputted to the user through a flickering operation so that the user can perceive a current operating state through relevant light being outputted. In this embodiment, although the optical lamp 620 has been implemented as an LED, the light display unit according to the present invention may be constructed in various manners depending on a design specification. Various lights can be outputted through the light display unit in response to the manipulation of the combined switch device. For example, the light output operation of the optical lamp includes the flickering operation. In the case where the user desires to adjust an audio device as the operating unit 60 which will be described later, a given audio mode is selected through the manipulation of the button switch 500 and a predetermined number of times or periods of the flickering operations such as twice flickering can be performed on the optical lamp 620 of the light display unit so that the mode selection by the user can be visually identified. In addition, in the case where the haptic actuator is implemented in an electric motor type, when a force for producing a detent feeling is applied upon the turning of the switch knob by the user, a predetermined detent operation can be visually perceived through the flickering of the optical lamp in response to the detent operation. Moreover, in the case where the turning operation of the switch knob exceeds a predetermined range according to the circumstances, it is also possible to allow the user to visually perceive a value of the range currently set by the user for a relevant operating unit through the combined switch device by changing the color of light outputted through the optical lamp.

That is, in the case where the user desires to select an air conditioning mode for manipulating an indoor air conditioning unit of a vehicle through the button switch and set a desired indoor temperature of the vehicle, it is also possible to allow the user to readily and rapidly perceive the approximate temperature value set by the user through the turning of the switch knob by implementing a structure in which brightness, saturation, and the like are increased or decreased using light having the preset color corresponding to the temperature range, for example, blue series light in case of FIGs. 17 to 21 and green series light in case of FIGs. 22 to 25, and red series light in case of FIGs. 26 to 29.

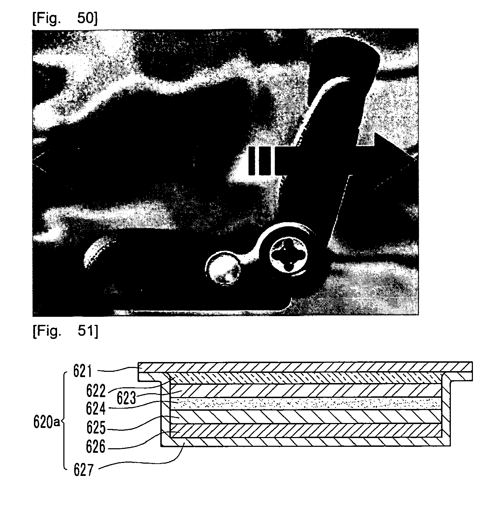

In the meantime, although it has been described in the above embodiment that the light display unit includes the optical lamp and the light guide simultaneously, it will be clear from the foregoing that the light display unit may have a construction in which it includes only the optical lamp. In addition, although it has been described in the above embodiment that the optical lamp is implemented as an LED, the optical lamp may be constructed in various manners besides the LED within a range of implementing an emissive structure of generating and outputting light. That is, the optical lamp may adopt an organic light emitting diode (OLED). In FIG. 4, although the optical lamp 620 has been implemented in the form of a point light source disposed on the printed circuit board 400, the optical lamp implemented as the OLED may be formed in plural numbers. Also, although not shown, the optical lamp may be implemented in various manners depending on design specification, including the form of a plane light source which is disposed in parallel with the printed circuit board and has a larger light exiting area. In the case where the optical lamp is implemented as the OLED of the plane light source type, the amount of light exiting the optical lamp is increased to allow the user to rapidly optically perceive a change in the operating state of the combined switch device or the operating unit through the combined switch device. In FIG. 51, there is shown a schematic cross-sectional view of an optical lamp 620a in the case where the optical lamp is implemented as an organic light emitting diode (OLED). The optical lamp 620a includes a first electrode 621 disposed on a plate such as a glass (not shown), a second electrode 626 disposed on the plate so as to be opposingly spaced apart from the first electrode 621, a hole injection and transport layer 623, a light emitting layer 624, and an electron transport and injection layer 625. The hole injection and transport layer 623, the light emitting layer 624, and the ctron transport and injection layer 625 are sequentially disposed bwtween the first electrode 621 and the second electrode 626. This construction is merely one exemple, and a modification of the construction of the light lamp 620a can be made within a range of including the light emitting layer interposed between the first electrode and the second electrode. The first electrode 621 and the second electrode 626 establishes an electrical connection with the printed circuit board, more specifically, the control unit (not shown) disposed on the combined switch device or the control unit 20 disposed on the combined switch module through a wiring (not shown). The first electrode 621 may be implemented as a transparent electrode made of at least one selected from indium tin oxide (ITO), indium zinc oxide (IZO), aluminum tin oxide (ATO), or zinc oxide (ZnO), and the second electrode 626 may be implemented as a reflective electrode made of at least one selected from Ag, Mg, Al, Pt, Pd, Au, Ni, Ir, and Cr. The hole injection and transport layer 623 may be formed of a material such as CuPc or NPD, and the electron transport and injection layer 625 may be formed of Alq(tris(8-quinolinolato)aluminum), LiF, or the like. The light emitting layer 624 may be formed of copper phthalocyanine (CuPc), Alq3, or the like. These electrodes and organic layers are hermetically sealed by a sealing material 627 to prevent a deterioration of the organic materials caused by the contact with outdoor air. Whether or not the first electrode 621 and the second electrode 626 emit light is controlled by the electrical signal applied thereto from the control unit so that the user can allow light to exit directly. Thus, it is possible to allow the user to directly and rapidly perceive the operation mode of the combined switch device through observation of light exiting the optical lamp besides a haptic function by the combined switch device.

In the meantime, in the above embodiment, the combined switch device may include a passive haptic signal generating means besides an active haptic signal generating means such as the haptic actuator to enable the user to make a haptic perception. That is, in FIGs. 20 to 23, there is shown a combined switch device 10b. In this embodiment, the same elements as those described in the aforementioned embodiment are denoted by the same reference numerals, and thus the repeated description thereof will be omitted to avoid redundancy and the description of only different elements from those in the aforementioned embodiment will be made. The switch unit of the combined switch device 10b further includes a switch detent unit 270. The switch detent unit 270 produces a detent feeling upon the turning of the switch knob 210. The switch detent unit 270 includes a detent block 2720, a detent body 2710, a detent plunger 2740, and a detent elastic member 2730. The detent block 2720 is disposed at the inside of the switch driving body 220 and has a detent 2721 formed on the inner circumferential surface thereof. The detent 2721 is provided in plural numbers. The detent 2721 includes a detent groove 2723 and a detent sloping surface 2725. The detent groove 2723 is formed as a depression or valley between two adjacent detents 2721 and the detent sloping surface 2725 is formed as an inner surface inclined to define the detent groove 2723.

The detent body 2710 is connected at one end thereof to the switch knob 210 and is disposed in the detent block 2720 so as to pass through the detent block. The detent body 2710 includes a detent body main part 2711, a detent body end 2713, and a detent body plunger receiving part 2715. The detent body end 2713 is formed at one end of the detent body main part 2711 so as to be engaged with a knob flywheel 2140 of the switch knob 210 to perform a rotational movement together with the switch knob 210. The detent body plunger receiving part 2715 is disposed at both sides of the detent body main part 2711 in a direction perpendicular to the longitudinal direction of the detent body main part 2711. The detent body plunger receiving part 2715 has a plunger receiving recess 2717 formed therein. The plunger receiving recess 2717 is formed to have an orientation angle of 180 degrees relative to the detent body main part 2711. Each of a pair of detent detent elastic members 2730 is inserted into each plunger receiving recess 2717 and the detent plunger 2740 is disposed at an outer end of a the detent elastic member 2730. Thus, the switch detent unit has a structure in which the detent elastic member 2730 abuts at one end thereof against an inner end of the plunger receiving recess 2717 and abuts at the other end thereof against an end of the detent plunger 2740. The detent body 2710 includes a support part 2720 formed at a bottom thereof. The detent body support part 2720 d is rotatably inserted into a shaft rotation support hollow portion 2223a of a shaft rotation support part 2221a so that a smooth rotation of the detent body 2710 can be performed. As mentioned above, the separate rotary switch 2620a and the sub printed circuit board 400a may be disposed at the switch detent unit 270. A rotary switch encoder 2621a of a rotary switch 2620a is fixedly mounted around the outer circumference of the detent body 2710 and a rotary switch sensor 2623a is mounted on one surface of the sub printed circuit board 400a through which the detent body 2710 passes so that a change in the electrical signal generated in response to the rotation of the rotary switch encoder 2621a is transferred to the control unit.

When the user turns the switch knob 210, a detent operation is performed in a state in which the detent plunger 2740 is brought into close contact with and the detent groove 2723 and the detent sloping surface 2725 of the detent block 2720. Through this detent operation, a detent feeling occurring due to the contact of the detent plunger 2740 with the detent groove 2723 and the detent sloping surface 2725 is transferred to user through the switch knob 210 so that a certain manipulation state can be haptically detected.

In the above embodiments, the combined switch device according to the present invention has a structure in which the switch driving body performs the tilting movement upon the directional movement of the switch knob, but it is not limited thereto. That is, in FIG. 24, there is shown a schematic exploded perspective view illustrating a combined switch device 10c according to yet another embodiment of the present invention. In this embodiment, the same elements as those described in the aforementioned embodiment are denoted by the same reference numerals, and thus the repeated description thereof will be omitted to avoid redundancy and the description of only different elements from those in the aforementioned embodiment will be made.

A switch knob 210c of the combined switch device 10c includes a knob body 2110c, a knob grip 2120, a knob cover 2130, and a knob flywheel 2140c. Unlike the aforementioned embodiment, the knob flywheel 2140c is disposed between the knob body 2110c and the knob cover 2130. A shaft mounting part 2111c is disposed in a through-hole 2141c formed at the center of the knob flywheel 2140c. The knob flywheel 2140c is fixed in its position on one surface of the knob body 2110c so that it is rotated together with the knob body 2110c. A shaft end 301c of the haptic actuator 300c is inserted into the knob body shaft mounting part 2111c and the knob body 2110c is rotated together with the haptic actuator 300c.

A switch driving body 220c includes a top part 2210c and a bottom part 2220c. The top part 2210c is substantialy the same as that in the aforementioned embodiment. The bottom part 2220c includes a horizontal portion 2221c and a vertical portion 2223c. The vertical portion 2223c is formed so as to extend vertically from one surface of the bottom part horizontal portion 2221c. The bottom part 2220c and the top part 2210c are engaged with each other to define a space to accommodate the haptic actuator 300c or the like so that the sub printed circuit board 400c and an encoder type rotary switch 2620a are disposed in the space to detect the turning state of the switch knob. As shown in FIG. 26, the rotary switch 2620c includes a rotary switch encoder 2621c and a rotary switch sensor 2623c. The rotary switch sensor 2623c is disposed on one surface of the sub printed circuit board 400c.

The directional switch 2610c includes a directional switch magnet 2611c and a directional switch sensor 2613c. The directional switch magnet 2611c of the directional switch 2610c is disposed at the horizontal portion 2221c of the bottom part. That is, a directional switch mounting part 2225c is disposed on the horizontal portion 2221c of the bottom part and has a directional switch mounting hole 2227c formed therein to define a space to mount the directional switch magnet 2611c. The directional switch sensor 2613c is disposed on the printed circuit board 400.

When an external force is applied to a side of the switch knob 210c, the horizontal portion 2221c of the bottom part of the switch driving body performs its sliding movement on a horizontal place. In this embodiment, this horizontal movement of the horizontal portion 2221c of the bottom part can be performed through a light guide 610c. A light display unit 600c includes a light guide 610c and an optical lamp 620. The light guide 610c disposed between the housing cover 110 and the housing strip 140. A sliding extension 617c is formed on the inner surface 611 of the light guide 610c and a sliding extension groove 619c is formed at the center of the sliding extension 617c. As shown in FIGs. 24 and 25, the sliding extension 617c of the light guide has a horizontal surface, and the sliding extension groove 619c of the light guide is formed in the shape for preventing an interference between the directional switch magnet 2611c and the directional switch sensor 2613c. Through such a sliding extension groove 619c, the directional switch magnet and the directional switch sensor can implement an arrangement structure in which they confront each other.

A haptic actuator 300c is implemented in an electric motor type and is seated in the switch driving body 220c as in the aforementioned embodiments. The switch driving body 220c performs its directional movement through the sliding movement unlike the switch driving bodies 220, 220a and 220b in the aforementioned embodiments. The switch driving body 220c performs its sliding movement on the plane in parallel with the printed circuit board 400 to perform a predetermined directional movement through the switch knob. At this time, the switch driving body-directional support 230c supports the directional movement of the switch driving body 220c and allows the switch driving body 220c to return its original position is implemented in a ball joint type. That is, the switch driving body 220c connected to the switch knob 210c performs its sliding movement on the plane, and the switch driving body-directional support 230c disposed at a lower portion of the switch driving body 220c and supporting the directional movement of the switch driving body 220c performs a ball joint rotational movement relative to the housing so that more stable directional movement of the switch knob 210c can be performed.

The switch driving body-directional support 230c includes a directional support fixing part 2320c, a directional support shaft 2310c, and a directional support body 2330c. The directional support fixing part 2320c is fixedly disposed in a housing 100, more specifically on the inner surface of a housing base 130. The directional support fixing part 2330c may be mounted to the housing base 130 by means of a separate fastening means such as a bolt. The directional support fixing part 2320c includes a directional support fixing body 2321c, a directional support fixing base 2325c, and a directional support fixing shaft contact 2323c. The directional support fixing body 2321c has a structure in which it has a space formed therein and is opened at both ends thereof in such a fashion that the directional support fixing shaft contact 2323c is formed on the inner surface of the directional support fixing body. The directional support fixing shaft contact 2323c is formed to have a radius of curvature in the shape that corresponds to the outer circumferential surface of the directional support shaft 2310c which will be described. The directional support fixing base 2325c is disposed at a lower portion of the directional support fixing body 2321c so that the directional support fixing part 2320c can be stably fixed to the housing base 130.

The directional support shaft 2310c is rotatably mounted to the directional support fixing part 2320c so as to be in close contact with the directional support fixing part. The directional support shaft 2310c includes a shaft body 2311c and a shaft body connecting part 2313c. The shaft body 2311c is formed in a ball structure of the ball joint having an outer surface of a spherical shape. The shaft body 2311c is in close contact with directional support shaft contact 2323c formed on the inner surface of the directional support fixing body 2321c in a relative rotation manner. This achieves a ball joint surface contact. The shaft body connecting part 2313c is formed at an upper end of the directional support shaft body 2311c so as to establish a relatively rotational connection with the directional support body 2330c which will be described. The shaft body connecting part 2313c has a shaft body connecting groove 2315c formed therein.

The directional support body 2330c is formed at a lower portion of the switch driving body 220c, more specifically on a bottom surface of the horizontal portion 2221c of the bottom part 2220c. The directional support body 2330c is composed of a plurality of rods extending toward an inner center of the switch driving body from a lower end of the switch driving body. In this embodiment, although the number of the directional support body 2330c is four, the directional support body 2330c may be constructed in various manners within a range of establishing the connection between the directional support body and the shaft body connecting part 2313c.

The shaft body connecting part 2313c has a shape of a groove larger than the directional support body 2330c. Thus, although the directional support shaft 2310c forms a tilting state by the ball joint contact, it is connected with the switch driving body so that it establishes a smooth connection with the directional support body that is allowed to be moved in a horizontal direction only and the transfer of a certain operating force or restoring force can be performed.

In addition, also in this embodiment, in the same manner as that in the aforementioned embodiments, the switch driving body-elastic support 240c is provided to elastically support the switch driving body. Except that the support holder 2410c is formed to extend from a bottom of the directional support shaft body 2311c of the directional support shaft 2310c, the switch driving body-elastic support 240c has a structure that is substantially the same as or similar to that in the above embodiments, Thus, its separate description will be omitted. Through this structure, when a side force P is applied to a side of the switch knob 210c disposed on the center axial line along the axial line Oc-Oc in a normal state of FIG. 28, the switch knob 210c is slid to perform its horizontal movement so that the central line is moved along the line Oc'-Oc' to cause the switch knob 210c to perform a horizontal displacement Wc and the switch driving body-elastic support 240c disposed at the lower portion of the switch driving body is tilted around the central point Gc to form an unstable state. In this case, a change in the magnetic field occurs due to a change in the position of the directional switch magnet, and thus a change in the electrical signal occurs in the directional switch sensor. The directional switch magnet and the directional switch sensor are disposed in plural numbers so that a more accurate position variation can be measured and detected.

When the side force applied to the a side of the switch knob 210c is removed, the switch driving body-elastic support forming the unstable state due to its tilting movement returns to its original position to for a stable state so that the switch knob can ultimately return to its original state.

In the meantime, in this embodiment, the switch unit may further include a separate switch driven by the enter switch operation. That is, as shown in FIG. 26, a protrusion 303c is formed at a bottom of the haptic actuator 300c or a corresponding element and a push switch 2630c implemented as a metal dome switch or a tact switch may further be disposed on one surface of the sub printed circuit board 400a to correspond to the protrusion 303c. Through this structure, in the case where a vertical force is applied to the switch knob 210c so that the witch knob is displaced from the line Hc-Hc to the line Hc'- Hc' to cause a vertical displacement to occur by d_{c}, the switch knob 210c transfers the vertical force to the push switch 2623c through the haptic actuator or a corresponding element to cause the push switch 2630c to transfer a change in the electrical signal to the control unit, or the like through the sub printed circuit board as shown in FIG. 30. In addition, simultaneously, the user who applies the vertical force to the switch knob can feel a certain clicking feeling through the switch knob in terms of the property of the push switch

In the meantime, as described above, the haptic actuator may be constructed in an electromagnet type as an element for allowing the user to make a haptic perception even when the switch driving body performs its sliding movement. That is, as shown in FIGs. 31 and 32, the haptic actuator 300d is constructed in the electromagnet type. In this embodiment, the same elements as those described in the aforementioned embodiment are denoted by the same reference numerals, and thus the repeated description thereof will be omitted to avoid redundancy. A shaft 310d of the hectic actuator includes a shaft body 311d, a shaft stopper 315d, and a protrusion 303d. As described above, the protrusion 303d is always in close contact with the push switch 2630c disposed on a sub printed circuit board 400a to cause the push switch to be driven through the vertical force applied to the switch knob 210c. The shaft stopper 315d supports the connection between the shaft stopper and haptic actuator disk.

Through such a construction, a change in the position or the rotation amount of the switch knob 210 manipulated by a user is transferred to the control unit through the switch unit, and the control unit applies a predetermined electrical control signal to the haptic actuator coil to provide a certain control signal, for example, a detent feeling, a vibration feeling, or a stopper feeling by utilizing the detected signal or the preset data so as to restrict or confine the operation of the haptic actuator disk so that the user can make a haptic perception through the switch knob.

Moreover, as in the above embodiments, the combined switch device may include a passive haptic signal generating means besides an active haptic signal generating means such as the haptic actuator to enable the user to make a haptic perception. That is, in FIGs. 33 and 34, there is shown a combined switch device 10e according to the present invention. In this embodiment, the same elements as those described in the aforementioned embodiments are denoted by the same reference numerals, and thus the repeated description thereof will be omitted to avoid redundancy. In this embodiment, unlike the switch detent unit described in the aforementioned embodiments, a protrusion 2719e is formed at a bottom of a detent body 2710e so that the protrusion 2719e can drive the push switch 2630c disposed on the sub printed circuit board 400a. Through this passive haptic signal generating means, a user can feel a certain clicking feeling upon the turning of the switch knob to prevent an excessive turning of he switch knob.

Also, in the meantime, the combined switch module 1 including the combined switch device 10 of the present invention further includes the elements for performing a predetermined control operation based on a change in the electrical signal generated from the directional switch 2610, the rotary switch 2620, and the button switch 520 by the directional movement, the rotary movement, and the enter movement of the switch knob 210 of the combined switch device 10 and the push movement of the button switch knob 510. The combined switch module 1 includes a control unit 20 that establishes an electrical connection with the combined switch device 10, an arithmetic logic unit 40, and a storage unit 30. Also the combined switch module 1 includes a display unit 50 and an operating unit 60, which are output elements. The control unit 20 establishes an electrical connection with the combined switch device 10, more specifically, the directional switch 2610, the rotary switch 2620, the button switch 520, and the optical lamp 620. The control unit 20 may be constructed in various manners, such as being disposed on the printed circuit board inside of the combined switch device, on a separate external electrical device, or the like according to the circumstances. The control unit 20 establishes an electrical connection with the combined switch device 10 to generate a predetermined control signal. At this time, the control unit 20 establishes an electrical connection with the storage unit 30 and the arithmetic logic unit 40. The control unit 20 can check an operation mode in which a user currently manipulates, a manipulation item in a relevant operation mode, an adjustment amount of a relevant manipulation item, and the like using a signal inputted thereto from combined switch device 10 and the preset data stored in the storage unit 30, and output a control signal in response to the relevant adjustment amount of the relevant manipulation item in the predetermined relevant operation mode for application to an operating unit such as, for example, a vehicle audio system, a vehicle seat position adjustment motor, a vehicle air conditioning unit, a vehicle navigator, and the like.

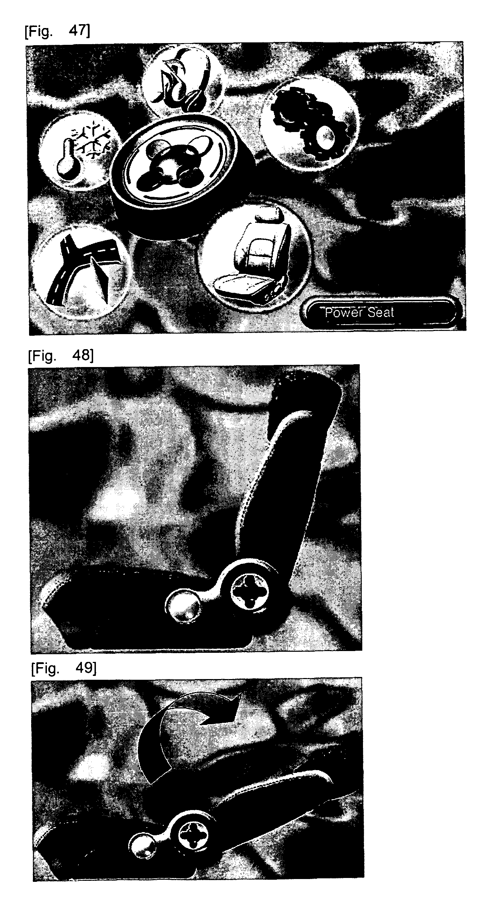

As shown in FIG. 47, a predetermined user interface screen (graphic user interface: GUI) may be implemented on the display unit 50 through the manipulation of the button switch and the switch knob of the combined switch device. An operation mode menu for adjustment of a certain operating unit such as, for example, a vehicle seat manipulation unit, a vehicle navigator, an air conditioning device, an audio device, and the like may be displayed on the user interface screen. As shown in FIG. 48, the user manipulates the switch knob or the button switch to select a predetermined menu corresponding to the position adjustment of the vehicle seat in order to adjust the position of the vehicle seat. At this time, in the case where the adjustment of the forward and rearward position or the vertical position of the seat is set to correspond to the directional movement of the switch knob, when the user exerts a side force to the switch knob to cause the directional movement of the switch knob of the combined switch device, the directional switch 2610 detects the exerted side force and applies a predetermined electrical signal to the control unit 20, which in turn generates a predetermined control signal responding to the applied electrical signal by using the applied electrical signal and the preset data stored in the storage unit 30. In this case, an arithematic operation process may be performed through the arithmetic logic unit 40, if necessary. In addition, the user may adjust an inclination angle of the vehicle seat through the manipulation of the rotary switch 2620. As such, the control signal from the control unit 20 is applied to an electric motor for adjusting the adjustment of the forward and rearward position or the vertical height and the inclination angle of the vehicle seat so that the use can select a vehicle seat adjustment mode as a desired relevant operation mode, a vehicle seat position and back seat inclination angle as a relevant manipulation item, and the adjustment amount of the position and inclination angle of the seat as a relevant adjustment amount. Such adjustment state can be displayed on the display unit 50 as shown in FIGs. 49 and 50.

Through the above process, the control unit 20 outputs a control signal responding to a relevant adjustment amount of a relevant manipulation item in a relevant operation mode selected by a user to the operating unit 60 to complete a predetermined control process.

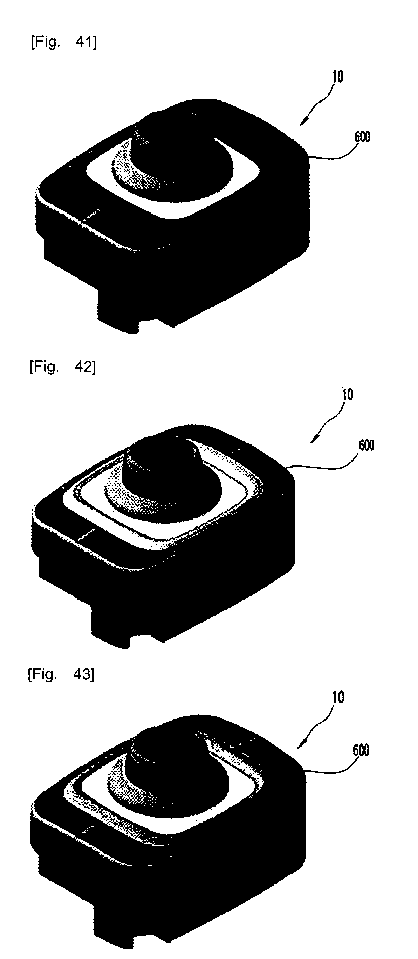

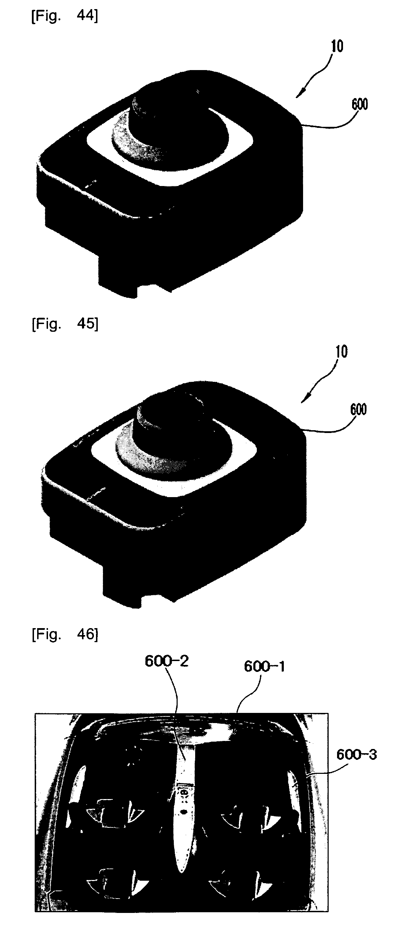

At the same time, the control unit 20 may output a predetermined control signal to other elements in order to enable the user to make a visual, haptic or audible perception. That is, the control unit 20 may apply an signal outputting light having the color or size corresponding to the manipulation amount (directional movement amount or rotary movement amount) of the switch knob 210, or the like, to the optical lamp 620 of the combined switch device 10 based on the signal applied thereto from the directional switch 2620 or the preset data stored in the storage unit 30. The output of light based on the operating state of the optical lamp 620 is shown in FIGs. 41 to 45. Such color adjustment may be performed by implementing the optical lamp 620 as an LED that outputs light of different colors. In addition, the adjustment of chromaticity, luminance, and luminous intensity may be performed through the adjustment of PWM and duty ratio of a signal applied to the optical lamp 620 implemented as an LED. The optical lamp can be displayed in red color in FIG. 41, in yellow color in FIG. 42, in green color in FIG. 43, in blue color in FIG. 44, and in pink color in FIG. 45, respectively. In the drawings, in the case where the optial lamp is displayed in white and black colors, it may be shown by a difference in light and shade.

Moreover, the state of a relevant operating mode selected by the user, a relevant manipulation item, and a relevant adjustment amount of the manipulation item may be outputted visually or audibly through the separate display unit 50 and/or the audio output unit 70 besides the optical lamp 620 to allow the user to make a visual or audible perception. For example, the display unit 50 may display an operatable menu according to the manipulation state of the combined switch device and a selected menu thereon.

Further, as described above, the control unit 20 may output a control signal for performing a vibration, detent or stopper operation to the haptic actuator 300 based on a signal from the directional switch 2610 to enable the user to make a haptic perception.

In the meantime, although it has been described in the above embodiments that the optical lamp is directly attached on the combined switch device, the optical lamp may be constructed in various manners within a range of outputting the switch device state manipulated through the combined switch device and the operating state of the operating unit in the form of light. That is, as shown in FIG. 46, the inventive combined switch module may include remote optical lamps 600-1, 600-2, and 600-3, which are spaced away from the combined switch device. These optical lamps are arranged to physically spaced apart from the combined switch device, but establish an electrical connection with the combined switch device or the control unit 20 through wirings, or the like. The remote optical lamps 600-1, 600-2, and 600-3 may be selectively arranged on a dashboard, centerfacia, a door side, or the like of the vehicle sothat the user can make a visual perception more easily, and may perform an illumination function such as a certain mood light.

The above embodiments are merely illustrative for the sake of describing the present invention and are not intended to limit the present invention. For example, the rotary switch according to the present invention may be implemented as a haptic actuator which is operated intermittently by the magnetic attraction force. In addition, the present invention may have a structure in which a seprate control unit is additionally provided on the combined switch device so that an electrical connection is established between the separate control unit and the combined switch device unlike the control unit of the combined switch module. As such, the present invention may be constructed in various manners within a range in which the switch supporting unit includes the switch driving body-directional support and the switch driving body-elastic support and/or the user can make a visual perception through the output of light, as well as in which it includes the combined switch device and/or combined switch module.

### INDUSTRIAL APPLICABILITY

The combined switch device and the combined switch module including the same according to the present invention enables is used in automobiles and can be implemented as a vehicle switch and safe device which prevents a driver's driving attention from being diverted and ensures a driver's safety driving in view of the fact that a user makes a haptic and visual perception stably, rapidly, and smoothly. In addition, the combined switch device and the combined switch module including the same may be applied variously in an automobile field as well as in a technology field that needs not only the switching operation of a manipulation panel of a game machine and a simulator but alos the sensory perception.

## Claims

1. A combined switch device (10) comprising:
a housing (100);
a printed circuit board (400) disposed in the housing (100); and
a switch unit (200) that comprises: a switch knob (210) which is rotatably disposed in the housing (100) in such a fashion as to be exposed at one end thereof to the housing (100); a switch driving body (220) disposed inside the housing (100), and connected with the switch knob (210); a switch supporting unit (230, 240) configured to support the switch driving body (220) with respect to the housing (100); and a switch (260) including a directional switch (2610) disposed on the switch driving body (220) and the printed circuit board (400) and configured to be driven by a motion performed on a plane that is perpendicular to a rotating axis (0-0) of the switch knob (210), and a rotary switch (2620) configured to be driven by the central rotation of the rotating axis (0-0) of the switch knob (210),
wherein the switch supporting unit (230, 240) comprises: a switch driving body-directional support (230) configured to support the switch driving body (220) to enable the switch knob (210) to be moved on the plane that is perpendicular to the rotating axis (0-0), and configured to support the switch driving body (220) to enable the switch knob (210) to be moved in the direction of the rotating axis (0-0); and a switch driving body-elastic support (240) configured to elastically support the movement of the switch knob (210) in the direction of the rotating axis (0-0),
wherein the switch driving body-directional support (230) is constructed in a universal joint type,
wherein the switch driving body-elastic support (240) comprises:
a support holder (2410) disposed beneath the switch driving body (220);
a support body (2430) disposed at the support holder (2410) such that the support body (2430) can perform its sliding movement;
a support elastic part (2420) configured to be in close contact at one end thereof with the support holder (2410) and at the other end thereof with the support body (2430), and configured to apply an elastic force between the support holder (2410) and the support body (2430); and
a support body counterpart (2460) disposed at the housing (100) to correspond to an end of the support body (2430) to allow the support body (2430) to perform the tilting movement,
**characterized in that**
the support body counterpart (2460) includes an apex end (2461) and a conical sloping surface (2463),
a support body load part (2435) is in close contact with the apex end (2461) when no external force is applied to the switch knob (210) to form a stable state, and when an external force applied to the switch knob (210) is removed, the elastic restoring force of the support elastic part (2420) acts to displace the support body load part (2435) to the apex end (2461).

2. The combined switch device according to claim 1, wherein the switch driving body-directional support (230) comprises a directional support fixing part (2330) fixedly disposed in the housing (100), a directional support frame (2310) rotatably mounted to the directional support fixing part (2330), and a directional support body (2320) disposed at the outside of the switch driving body (220) and mounted to the directional support frame (2310) so as to rotated about an axis perpendicular to a rotating axis of the directional support frame (2310) relative to the directional support fixing part (2330).

3. The combined switch device according to claim 1, wherein the directional switch (2610) comprises: a directional switch magnet (2611) disposed at the outside of the switch driving body (220); and a the directional switch sensor (2613) disposed one side of the printed circuit board to correspond to the directional switch magnet (2611) and configured to be driven by the tilting movement of the switch knob (210).

4. The combined switch device according to claim 1, wherein the switch unit (200) further comprises a switch knob rotary unit (250) comprising a rotary switch rotation roller (2510) rotatably disposed on the outer circumference of the switch driving body (220) and a rotary switch rotation roller counterpart (2520) disposed at a lower end of the switch knob (210) and configured to be engaged with the rotary switch rotation roller (2510) in such a fashion as to be rotatable relative to the rotary switch rotation roller (2510).

5. The combined switch device according to claim 1, further comprising a sub printed circuit board (400a) disposed below the switch knob (210), wherein the rotary switch (2620) comprises a rotary switch encoder (2621a) disposed below the switch knob (210) and configured to be rotated together with the switch knob (210), and a rotary switch sensor (2623a) disposed on one surface of the sub printed circuit board (400a) to correspond to the rotary switch encoder (2621a).

6. The combined switch device according to claim 1, further comprising a sub printed circuit board (400a) disposed at a lower end of the switch knob (210), wherein the rotary switch (2620) comprises a rotary switch encoder (2621) of a slit type mounted at the lower end of the switch knob (210), and a rotary switch sensor (2623a) of a photo sensor type disposed on one surface of the sub printed circuit board (400a) to correspond to the rotary switch encoder (2621a).

7. The combined switch device according to claim 1, further comprising a haptic actuator (300a, 300c, 300d) disposed in the switch driving body (220) so as to be connected to the switch knob (210).

8. The combined switch device according to claim 7, wherein the haptic actuator (300, 300a, 300c, 300d) is constructed in an electric motor type.

9. The combined switch device according to claim 7, wherein the haptic actuator (300, 300a, 300c, 300d) is constructed in an electromagnet type.

10. The combined switch device according to claim 9, wherein the haptic actuator (300a) comprises:
a haptic actuator shaft (310a) connected with the switch knob (210);
a haptic actuator housing (320a) disposed at the inside of the switch driving body (220a);
a haptic actuator bobbin (330a) disposed at the inside of the hapctic actuator housing (320a) in such a fashion that the haptic actuator shaft (310a) movably passes therethrough, the haptic actuator bobbin (330a) having a coil wound therearound; and
a haptic actuator disk (340a) mounted around an end of the haptic actuator shaft (310a) and brought into close contact with an end of the haptic actuator housing (320a).

11. The combined switch device according to claim 1, further comprising a light display unit (600) including an optical lamp (620) for generating and externally outputting light based on an electrical signal of the switch unit (200).

12. The combined switch device according to claim 11, wherein the optical lamp (620) is a light emitting diode (LED) or an organic light emitting diode (OLED).

13. A combined switch device (10c) comprising:
a housing (100);
a printed circuit board (400c) disposed in the housing; and
a switch unit (200c) that comprises: a switch knob (210c) which is rotatably disposed in the housing in such a fashion as to be exposed at one end thereof to the housing; a switch driving body (220c) disposed inside the housing (100), and connected with the switch knob (210c); a switch supporting unit (230c, 240c) configured to support the switch driving body (220c) with respect to the housing; and a switch (260c) including a directional switch (2610c) disposed on the switch driving body (220c) and the printed circuit board (400c) and configured to be driven by a motion performed on a plane that is perpendicular to a rotating axis (0-0) of the switch knob (210c), and a rotary switch (2620c) configured to be driven by the central rotation of the rotating axis (0-0) of the switch knob (210c),
wherein the switch supporting unit (230c, 240c) comprises: a switch driving body-directional support (230c) configured to support the directional movement of the switch driving body (220c) to enable the switch knob (210c) to perform its sliding movement on the plane parallel with the printed circuit board (400c), and configured to support the switch driving body (220c) to enable the switch knob (210c) to be moved in the direction of the rotating axis (0-0); and a switch driving body-elastic support (240c) configured to elastically support the movement of the switch knob (210c) in the direction of the rotating axis (0-0),
wherein the switch driving body-directional support (230c) is constructed in a ball joint type,
wherein the switch driving body-elastic support (240c) comprises:
a support holder (2410c) disposed beneath the switch driving body (220c);
a support body (2430) disposed at the support holder (2410c) such that the support body (2430) can perform its sliding movement;
a support elastic part (2420) configured to be in close contact at one end thereof with the support holder (2410c) and at the other end thereof with the support body (2430), and configured to apply an elastic force between the support holder (2410c) and the support body (2430); and
a support body counterpart (2460) disposed at the housing (100) to correspond to an end of the support body (2430) to allow the support body (2430) to perform the tilting movement,
**characterized in that**
the support body counterpart (2460) includes an apex end (2461) and a conical sloping surface (2463),
a support body load part (2435) is in close contact with the apex end (2461) when no external force is applied to the switch knob (210c) to form a stable state, and when an external force applied to the switch knob (210c) is removed, the elastic restoring force of the support elastic part (2420) acts to displace the support body load part (2435) to the apex end (2461).

14. The combined switch device according to claim 13, further comprising a haptic actuator (300a, 300c, 300d) disposed in the switch driving body (220c) so as to be connected to the switch knob (210c).

15. The combined switch device according to claim 13 further comprising a light display unit (600) including an optical lamp (620) for generating and externally outputting light based on an electrical signal of the switch unit (200c).

16. A combined switch module (1) according to claim 1 comprising:
a module housing (2) in which the combined switch device (10) is mounted;
a control unit (20) disposed in the module housing (2) and configured to establish an electrical connection with the combined switch device (10);
a storage unit (30) configured to establish an electrical connection with the control unit (20) and store preset data for an operation mode corresponding to the operation of the combined switch device (10); and
a display unit (50) configured to establish an electrical connection with the control unit (20) and display the operation mode of the combined switch device (10) thereon.

## Patentansprüche

1. Kombinierte Schaltvorrichtung (10), die Folgendes umfasst:
ein Gehäuse (100);
eine gedruckte Leiterplatte (400), die in dem Gehäuse (100) angeordnet ist; und
eine Schalteinheit (200), die Folgendes umfasst: einen Schaltknebel (210), der in dem Gehäuse (100) drehbar angeordnet ist, derart, dass er an seinem einen Ende bei dem Gehäuse (100) freiliegt; einen Schalterantriebskörper (220), der in dem Gehäuse (100) angeordnet ist und mit dem Schaltknebel (210) verbunden ist; eine Schalterlagerungseinheit (230, 240), die konfiguriert ist, den Schalterantriebskörper (220) in Bezug auf das Gehäuse (100) zu lagern; und einen Schalter (260), der einen Richtungsschalter (2610), der an dem Schalterantriebskörper (220) und der gedruckten Leiterplatte (400) angeordnet ist und konfiguriert ist, durch eine Bewegung angetrieben zu werden, die auf einer Ebene ausgeführt wird, die zu einer Drehachse (0-0) des Schaltknebels (210) senkrecht liegt, und einen Drehschalter (2620), der konfiguriert ist, durch die zentrale Drehung der Drehachse (0-0) des Schaltknebels (210) angetrieben zu werden, enthält,
wobei die Schalterlagerungseinheit (230, 240) Folgendes umfasst: eine Schalterantriebskörper-Richtungslagerung (230), die konfiguriert ist, den Schalterantriebskörper (220) so zu unterstützen, dass der Schaltknebel (210) auf der Ebene bewegt werden kann, die senkrecht zu der Drehachse (0-0) liegt, und konfiguriert ist, den Schalterantriebskörper (220) so zu unterstützen, dass der Schaltknebel (210) in Richtung der Drehachse (0-0) bewegt werden kann; und eine elastische Lagerung (240) des Schalterantriebskörpers, die konfiguriert ist, die Bewegung des Schaltknebels (210) in der Richtung der Drehachse (0-0) elastisch zu unterstützen,
wobei die Schalterantriebskörper-Richtungslagerung (230) in der Art eines Universalgelenks konstruiert ist,
wobei die elastische Lagerung (240) des Schalterantriebskörpers Folgendes umfasst:
ein Lagerungshalteelement (2410), das unter dem Schalterantriebskörper (220) angeordnet ist;
einen Lagerungskörper (2430), der bei dem Lagerungshalteelement (2410) so angeordnet ist, dass der Lagerungskörper (2430) seine Gleitbewegung ausführen kann;
ein elastisches Lagerungsbauteil (2420), das so konfiguriert ist, dass es an seinem einen Ende mit dem Lagerungshalteelement (2410) und an seinem anderen Ende mit dem Lagerungskörper (2430) in direktem Kontakt ist, und konfiguriert ist, eine elastische Kraft zwischen dem Lagerungshalteelement (2410) und dem Lagerungskörper (2430) auszuüben; und
ein Lagerungskörper-Gegenstück (2460), das bei dem Gehäuse (100) angeordnet ist, damit es mit einem Ende des Lagerungskörpers (2430) übereinstimmt, damit der Lagerungskörper (2430) die Kippbewegung ausführen kann,
**dadurch gekennzeichnet, dass** das Lagerungskörper-Gegenstück (2460) ein Scheitelende (2461) und eine konisch schräge Oberfläche (2463) umfasst,
ein Lagerungskörper-Belastungsbauteil (2435) in direktem Kontakt mit dem Ende (2461) der Kegelspitze ist, wenn keine äußere Kraft auf den Schaltknebel (210) ausgeübt wird, um einen stabilen Zustand zu bilden, und wenn eine äußere Kraft, die auf den Schaltknebel (210) ausgeübt wird, zurückgenommen wird, die elastische Wiederherstellungskraft des elastischen Lagerungsbauteils (2420) bewirkt, dass das Lagerungskörper-Belastungsbauteil (2435) zu dem Ende (2461) der Kegelspitze verlagert wird.

2. Kombinierte Schaltvorrichtung nach Anspruch 1, wobei die Schalterantriebskörper-Richtungslagerung (230) ein Richtungslagerung-Befestigungsbauteil (2330), das in dem Gehäuse (100) fest angeordnet ist, einen Richtungslagerung-Rahmen (2310), der in dem Richtungslagerung-Befestigungsbauteil (2330) drehbar angebracht ist, und einen Richtungslagerungskörper (2320), der an der Außenseite des Schalterantriebskörpers (220) angeordnet ist und an dem Richtungslagerung-Rahmen (2310) so angebracht ist, dass er um eine Achse gedreht wird, die senkrecht zu einer Drehachse des Richtungslagerung-Rahmens (2310) in Bezug auf das Richtungslagerung-Befestigungsbauteil (2330) ist, umfasst.

3. Kombinierte Schaltvorrichtung nach Anspruch 1, wobei der Richtungsschalter (2610) Folgendes umfasst: einen Richtungsschaltermagnet (2611), der an der Außenseite des Schalterantriebskörpers (220) angeordnet ist; und einen Richtungsschaltersensor (2613), der an einer Seite der gedruckten Leiterplatte angeordnet ist, um mit dem Richtungsschaltermagneten (2611) übereinzustimmen, und konfiguriert ist, durch die Kippbewegung des Schaltknebels (210) angetrieben zu werden.

4. Kombinierte Schaltvorrichtung nach Anspruch 1, wobei die Schaltereinheit (200) ferner eine Schaltknebel-Dreheinheit (250) umfasst, die eine Drehschalter-Drehwalze (2510), die an dem Außenumfang des Schalterantriebskörpers (220) drehbar angeordnet ist, und ein Gegenstück (2520) der Drehschalter-Drehwalze, das bei einem unteren Ende des Schaltknebels (210) angeordnet ist und konfiguriert ist, mit der Drehschalter-Drehwalze (2510) in Eingriff zu gelangen, derart, dass es in Bezug auf die Drehschalter-Drehwalze (2510) drehbar ist, umfasst.

5. Kombinierte Schaltvorrichtung nach Anspruch 1, die ferner eine zusätzliche gedruckte Leiterplatte (400a) umfasst, die unter dem Schaltknebel (210) angeordnet ist, wobei der Drehschalter (2620) eine Drehschalter-Codiervorrichtung (2621a), die unter dem Schaltknebel (210) angeordnet ist und konfiguriert ist, zusammen mit dem Schaltknebel (210) gedreht zu werden, und einen Drehschaltersensor (2623a), der an einer Oberfläche der zusätzlichen gedruckten Leiterplatte (400a) angeordnet ist, um mit der Drehschalter-Codiervorrichtung (2621a) übereinzustimmen, umfasst.

6. Kombinierte Schaltvorrichtung nach Anspruch 1, die ferner eine zusätzliche gedruckte Leiterplatte (400a) umfasst, die bei einem unteren Ende des Schaltknebels (210) angeordnet ist, wobei der Drehschalter (2620) eine Drehschalter-Codiervorrichtung (2621a) eines Schlitz-Typs, der an dem unteren Ende des Schaltknebels (210) angeordnet ist, und einen Drehschaltersensor (2623a) eines Photosensor-Typs, der auf einer Oberfläche der zusätzlichen gedruckten Leiterplatte (400a) so angeordnet ist, dass er der Drehschalter-Codiervorrichtung (2621a) entspricht, umfasst.

7. Kombinierte Schaltvorrichtung nach Anspruch 1, die ferner einen haptischen Aktuator (300a, 300c, 300d) umfasst, der in dem Schalterantriebskörper (220) so angeordnet ist, dass er mit dem Schaltknebel (210) verbunden ist.

8. Kombinierte Schaltvorrichtung nach Anspruch 7, wobei der haptische Aktuator (300, 300a, 300c, 300d) in der Art eines Elektromotors konstruiert ist.

9. Kombinierte Schaltvorrichtung nach Anspruch 7, wobei der haptische Aktuator (300, 300a, 300c, 300d) in der Art eines Elektromagneten konstruiert ist.

10. Kombinierte Schaltvorrichtung nach Anspruch 9, wobei der haptische Aktuator (300a) Folgendes umfasst:
eine Welle (310a) für den haptischen Aktuator, die mit dem Schaltknebel (210) verbunden ist;
ein Gehäuse (320a) für den haptischen Aktuator, das an der Innenseite des Schalterantriebskörpers (220a) angeordnet ist;
einen Spulenträger (330a) für den haptischen Aktuator, der an der Innenseite des Gehäuses (320a) für den haptischen Aktuator angeordnet ist, derart, dass die Welle (310a) für den haptischen Aktuator beweglich dort hindurch verläuft, wobei der Spulenträger (330a) für den haptischen Aktuator mit eine Spule umwickelt ist; und
eine Scheibe (340a) für den haptischen Aktuator, die um ein Ende der Welle (310a) für den haptischen Aktuator angebracht ist und in direkten Kontakt mit einem Ende des Gehäuses (320a) des haptischen Aktuators gebracht wird.

11. Kombinierte Schaltvorrichtung nach Anspruch 1, die ferner eine Lichtanzeigeeinheit (600) umfasst, die eine optische Lampe (620) zum Erzeugen und Ausgeben von Licht nach außen auf Basis eines elektrischen Signals der Schalteinheit (200) umfasst.

12. Kombinierte Schaltvorrichtung nach Anspruch 11, wobei die optische Lampe (620) eine Leuchtdiode (LED) oder eine organische Leuchtdiode (OLED) ist.

13. Kombinierte Schaltvorrichtung (10c), die Folgendes umfasst:
ein Gehäuse (100);
eine gedruckte Leiterplatte (400c), die in dem Gehäuse angeordnet ist; und
eine Schalteinheit (200c), die Folgendes umfasst: einen Schaltknebel (210c), der in dem Gehäuse drehbar angeordnet ist, derart, dass er an seinem einen Ende bei dem Gehäuse freiliegt; einen Schalterantriebskörper (220c), der in dem Gehäuse (100) angeordnet ist und mit dem Schaltknebel (210c) verbunden ist; eine Schalterlagerungseinheit (230c, 240c), die konfiguriert ist, den Schalterantriebskörper (220c) in Bezug auf das Gehäuse zu lagern; und einen Schalter (260c), der einen Richtungsschalter (2610c), der an dem Schalterantriebskörper (220c) und der gedruckten Leiterplatte (400c) angeordnet ist und konfiguriert ist, durch eine Bewegung angetrieben zu werden, die auf einer Ebene ausgeführt wird, die senkrecht zu einer Drehachse (0-0) des Schaltknebels (210c) liegt, und einen Drehschalter (2620c), der konfiguriert ist, durch die zentrale Drehung der Drehachse (0-0) des Schaltknebels (210c) angetrieben zu werden, umfasst,
wobei die Schalterlagerungseinheit (230c, 240c) Folgendes umfasst: eine Schalterantriebskörper-Richtungslagerung (230c), die konfiguriert ist, die Richtungsbewegung des Schalterantriebskörpers (220c) so zu unterstützen, dass der Schaltknebel (210) seine Gleitbewegung auf der Ebene parallel zu der gedruckten Leiterplatte (400c) ausführen kann, und konfiguriert ist, den Schalterantriebskörper (220c) so zu unterstützen, dass der Schaltknebel (210c) in Richtung der Drehachse (0-0) bewegt werden kann; und wobei eine elastische Lagerung (240c) für den Schalterantriebskörper konfiguriert ist, die Bewegung des Schaltknebels (210c) in Richtung der Drehachse (0-0) elastisch zu unterstützen,
wobei die Schalterantriebskörper-Richtungslagerung (230c) in der Art eines Kugelgelenks konstruiert ist,
wobei die elastische Lagerung (240c) des Schalterantriebskörpers Folgendes umfasst:
ein Lagerungshalteelement (2410c), das unter dem Schalterantriebskörper (220c) angeordnet ist;
einen Lagerungskörper (2430), der bei dem Lagerungshalteelement (2410c) so angeordnet ist, dass der Lagerungskörper (2430) seine Gleitbewegung ausführen kann;
ein elastisches Lagerungsbauteil (2420), das so konfiguriert ist, dass es an seinem einen Ende mit dem Lagerungshalteelement (2410c) und an seinem anderen Ende mit dem Lagerungskörper (2430) in direktem Kontakt ist, und konfiguriert ist, eine elastische Kraft zwischen dem Lagerungshalteelement (2410c) und dem Lagerungskörper (2430) auszuüben; und
ein Lagerungskörper-Gegenstück (2460), das an dem Gehäuse (100) angeordnet ist, damit es mit einem Ende des Lagerungskörpers (2430) übereinstimmt, damit der Lagerungskörper (2430) die Kippbewegung ausführen kann,
**dadurch gekennzeichnet, dass**
das Lagerungskörper-Gegenstück (2460) ein Scheitelende (2461) und eine konisch schräge Oberfläche (2463) umfasst,
ein Lagerungskörper-Belastungsbauteil (2435) in direktem Kontakt mit dem Ende (2461) der Kegelspitze ist, wenn keine äußere Kraft auf den Schaltknebel (210c) ausgeübt wird, um einen stabilen Zustand zu bilden, und wenn eine äußere Kraft, die auf den Schaltknebel (210c) ausgeübt wird, zurückgenommen wird, die elastische Wiederherstellungskraft des elastischen Lagerungsbauteils (2420) bewirkt, dass das Lagerungskörper-Belastungsbauteil (2435) zu dem Ende (2461) der Kegelspitze verlagert wird.

14. Kombinierte Schaltvorrichtung nach Anspruch 13, die ferner einen haptischen Aktuator (300a, 300c, 300d) umfasst, der in dem Schalterantriebskörper (220c) so angeordnet ist, dass er mit dem Schaltknebel (210c) verbunden ist.

15. Kombinierte Schaltvorrichtung nach Anspruch 13, die ferner eine Lichtanzeigeeinheit (600) umfasst, die eine optische Lampe (620) zum Erzeugen und Aus von Licht geben nach außen auf Basis eines elektrischen Signals der Schalteinheit (200c) umfasst.

16. Kombiniertes Schaltmodul (1) nach Anspruch 1, das ferner Folgendes umfasst:
ein Modulgehäuse (2), in dem die kombinierte Schaltvorrichtung (10) angebracht ist;
eine Steuereinheit (20), die in dem Modulgehäuse (2) angeordnet ist und konfiguriert ist, eine elektrische Verbindung mit der kombinierten Schaltvorrichtung (10) herzustellen;
eine Speichereinheit (30), die konfiguriert ist, eine elektrische Verbindung mit der Steuereinheit (20) herzustellen und voreingestellte Daten für eine Betriebsart entsprechend dem Betrieb der kombinierten Schaltvorrichtung (10) zu speichern; und
eine Anzeigeeinheit (50), die konfiguriert ist, eine elektrische Verbindung mit der Steuereinheit (20) herzustellen und die Betriebsart der kombinierten Schaltvorrichtung (10) darauf anzuzeigen.

## Revendications

1. Dispositif de commutation combiné (10) comprenant :
un boîtier (100) ;
une carte à circuit imprimé (400) disposée dans le boîtier (100) ; et
une unité de commutateur (200) comprenant : un bouton de commutateur (210) disposé de façon rotative dans le boîtier (100) de manière à être exposé au boîtier (100) à une extrémité de celui-ci ; un corps d'entraînement de commutateur (220) disposé à l'intérieur du boîtier (100) et relié au bouton de commutateur (210) ; une unité de support de commutateur (230, 240) configurée pour supporter le corps d'entraînement de commutateur (220) par rapport au boîtier (100) ; et un commutateur (260) comprenant un commutateur directionnel (2610) disposé sur le corps d'entraînement de commutateur (220) et la carte à circuit imprimé (400) et configuré pour être entraîné par un mouvement exécuté sur un plan perpendiculaire à un axe de rotation (0-0) du bouton de commutateur (210), et un commutateur rotatif (2620) configuré pour être entraîné par la rotation centrale de l'axe de rotation (0-0) du bouton de commutateur (210),
dans lequel l'unité de support de commutateur (230, 240) comprend : un support directionnel de corps d'entraînement de commutateur (230) configuré pour supporter le corps d'entraînement de commutateur (220) afin de permettre au bouton de commutateur (210) de se déplacer sur le plan perpendiculaire à l'axe de rotation (0-0), et configuré pour supporter le corps d'entraînement de commutateur (220) afin de permettre au bouton de commutateur (210) de se déplacer dans la direction de l'axe de rotation (0-0) ; et un support élastique de corps d'entraînement de commutateur (240) configuré pour supporter de façon élastique le mouvement du bouton de commutateur (210) dans la direction de l'axe de rotation (0-0),
dans lequel le support directionnel de corps d'entraînement de commutateur (230) est construit selon le type joint universel,
dans lequel le support élastique de corps d'entraînement de commutateur (240) comprend :
une monture de support (2410) disposée en dessous du corps d'entraînement de commutateur (220) ;
un corps de support (2430) disposé au niveau de la monture de support (2410) de manière à ce que le corps de support (2430) puisse exécuter son mouvement de coulissement ;
une partie élastique de support (2420) configurée pour se trouver en contact étroit avec la monture de support (2410) à une extrémité de celle-ci et avec le corps de support (2430) à l'autre extrémité de celle-ci, et configurée pour appliquer une force élastique entre la monture de support (2410) et le corps de support (2430) ; et
une contre-pièce de corps de support (2460) disposée au niveau du boîtier (100) pour correspondre à une extrémité du corps de support (2430) afin de permettre au corps de support (2430) d'exécuter un mouvement d'inclinaison,
**caractérisé en ce que**
la contre-pièce de corps de support (2460) comprend une extrémité de pointe (2461) et une surface inclinée conique (2463),
une partie de chargement de corps de support (2435) est en contact étroit avec l'extrémité de pointe (2461) lorsqu'aucune force extérieure n'est appliquée au bouton de commutateur (210) pour former état stable, et lorsqu'une force extérieure appliquée au bouton de commutateur (210) est supprimée, la force de rappel élastique de la partie élastique de support (2420) agit pour déplacer la partie de chargement de corps de support (2435) vers l'extrémité de pointe (2461).

2. Dispositif de commutation combiné selon la revendication 1, dans lequel le support directionnel de corps d'entraînement de commutateur (230) comprend une partie de fixation de support directionnel (2330) disposée fixement dans le boîtier (100), un cadre de support directionnel (2310) monté de façon rotative sur la partie de fixation de support directionnel (2330), et un corps de support directionnel (2320) disposé à l'extérieur du corps d'entraînement de commutateur (220) et monté sur le cadre de support directionnel (2310) de manière à tourner autour d'un axe perpendiculaire à un axe de rotation du cadre de support directionnel (2310) par rapport à la partie de fixation de support directionnel (2330).

3. Dispositif de commutation combiné selon la revendication 1, dans lequel le commutateur directionnel (2610) comprend : un aimant de commutateur directionnel (2611) disposé à l'extérieur du corps d'entraînement de commutateur (220) ; et un capteur de commutateur directionnel (2613) disposé sur un côté de la carte à circuit imprimé pour correspondre à l'aimant de commutateur directionnel (2611) et configuré pour être entraîné par le mouvement d'inclinaison du bouton de commutateur (210).

4. Dispositif de commutation combiné selon la revendication 1, dans lequel l'unité de commutateur (200) comprend en outre une unité rotative de bouton de commutateur (250) comprenant un roulement de commutateur rotatif (2510) disposé de façon rotative sur la circonférence extérieure du corps d'entraînement de commutateur (220), et une contre-pièce de roulement de commutateur rotatif (2520) disposée à une extrémité inférieure du bouton de commutateur (210) et configurée pour s'engager avec le roulement de commutateur rotatif (2510) de manière à pouvoir tourner par rapport au roulement de commutateur rotatif (2510).

5. Dispositif de commutation combiné selon la revendication 1, comprenant en outre une sous-carte à circuit imprimé (400a) disposée en dessous du bouton de commutateur (210), le commutateur rotatif (2620) comprenant un encodeur de commutateur rotatif (2621a) disposé en dessous du bouton de commutateur (210) et configuré pour effectuer une rotation ensemble avec le bouton de commutateur (210), et un capteur de commutateur rotatif (2623a) disposé sur une surface de la sous-carte à circuit imprimé (400a) pour correspondre à l'encodeur de commutateur rotatif (2621a).

6. Dispositif de commutation combiné selon la revendication 1, comprenant en outre une sous-carte à circuit imprimé (400a) disposée à une extrémité inférieure du bouton de commutateur (210), le commutateur rotatif (2620) comprenant un encodeur de commutateur rotatif (2621) du type fente monté à l'extrémité inférieure du bouton de commutateur (210), et un capteur de commutateur rotatif (2623a) du type capteur optique disposé sur une surface de la sous-carte à circuit imprimé (400a) pour correspondre à l'encodeur de commutateur rotatif (2621a).

7. Dispositif de commutation combiné selon la revendication 1, comprenant en outre un actionneur haptique (300a, 300c, 300d) disposé dans le corps d'entraînement de commutateur (220) de manière à être connecté au bouton de commutateur (210).

8. Dispositif de commutation combiné selon la revendication 7, dans lequel l'actionneur haptique (300, 300a, 300c, 300d) est construit selon un type de moteur électrique.

9. Dispositif de commutation combiné selon la revendication 7, dans lequel l'actionneur haptique (300, 300a, 300c, 300d) est construit selon un type d'électroaimant.

10. Dispositif de commutation combiné selon la revendication 9, dans lequel l'actionneur haptique (300a) comprend :
un arbre d'actionneur haptique (310a) relié au bouton de commutateur (210) ;
un boîtier d'actionneur haptique (320a) disposé à l'intérieur du corps d'entraînement de commutateur (220a) ;
une bobine d'actionneur haptique (330a) disposée à l'intérieur du boîtier d'actionneur haptique (320a) de manière à ce que l'arbre d'actionneur haptique (310a) traverse celui-ci de façon mobile, la bobine d'actionneur haptique (330a) comportant un serpentin enroulé autour de celle-ci ; et
un disque d'actionneur haptique (340a) monté autour d'une extrémité de l'arbre d'actionneur haptique (310a) et mis en contact étroit avec une extrémité du boîtier d'actionneur haptique (320a).

11. Dispositif de commutation combiné selon la revendication 1, comprenant en outre une unité d'affichage lumineuse (600) comprenant une lampe optique (620) destinée à générer une lumière et à émettre celle-ci extérieurement sur la base d'un signal électrique de l'unité de commutateur (200).

12. Dispositif de commutation combiné selon la revendication 11, dans lequel la lampe optique (620) est une diode électroluminescente (DEL) ou une diode électroluminescente organique (DELO).

13. Dispositif de commutation combiné (10c) comprenant :
un boîtier (100) ;
une carte à circuit imprimé (400c) disposée dans le boîtier ; et
une unité de commutateur (200c) comprenant : un bouton de commutateur (210c) disposé de façon rotative dans le boîtier de manière à être exposé au boîtier à une extrémité de celui-ci ; un corps d'entraînement de commutateur (220c) disposé à l'intérieur du boîtier (100) et relié au bouton de commutateur (210c) ; une unité de support de commutateur (230c, 240c) configurée pour supporter le corps d'entraînement de commutateur (220c) par rapport au boîtier ; et un commutateur (260c) comprenant un commutateur directionnel (2610c) disposé sur le corps d'entraînement de commutateur (220c) et la carte à circuit imprimé (400c) et configuré pour être entraîné par un mouvement exécuté sur un plan perpendiculaire à un axe de rotation (0-0) du bouton de commutateur (210c), et un commutateur rotatif (2620c) configuré pour être entraîné par la rotation centrale de l'axe de rotation (0-0) du bouton de commutateur (210c),
dans lequel l'unité de support de commutateur (230c, 240c) comprend : un support directionnel de corps d'entraînement de commutateur (230c) configuré pour supporter le mouvement directionnel corps d'entraînement de commutateur (220c) afin de permettre au bouton de commutateur (210c) d'exécuter son mouvement de coulissement sur le plan parallèle à la carte à circuit imprimé (400c), et configuré pour supporter le corps d'entraînement de commutateur (220c) afin de permettre au bouton de commutateur (210c) de se déplacer dans la direction de l'axe de rotation (0-0) ; et un support élastique de corps d'entraînement de commutateur (240c) configuré pour supporter de façon élastique le mouvement du bouton de commutateur (210c) dans la direction de l'axe de rotation (0-0),
dans lequel le support directionnel de corps d'entraînement de commutateur (230c) est construit selon un type de joint à rotule,
dans lequel le support élastique de corps d'entraînement de commutateur (240c) comprend :
une monture de support (2410c) disposée en dessous du corps d'entraînement de commutateur (220c) ;
un corps de support (2430) disposé au niveau de la monture de support (2410c) de manière à ce que le corps de support (2430) puisse exécuter son mouvement de coulissement ;
une partie élastique de support (2420) configurée pour se trouver en contact étroit avec la monture de support (2410c) à une extrémité de celle-ci et avec le corps de support (2430) à l'autre extrémité de celle-ci, et configurée pour appliquer une force élastique entre la monture de support (2410c) et le corps de support (2430) ; et
une contre-pièce de corps de support (2460) disposée au niveau du boîtier (100) pour correspondre à une extrémité du corps de support (2430) afin de permettre au corps de support (2430) d'exécuter le mouvement d'inclinaison,
**caractérisé en ce que**
la contre-pièce de corps de support (2460) comprend une extrémité de pointe (2461) et une surface inclinée conique (2463),
une partie de chargement de corps de support (2435) est en contact étroit avec l'extrémité de pointe (2461) lorsqu'aucune force extérieure n'est appliquée au bouton de commutateur (210c) pour former état stable, et lorsqu'une force extérieure appliquée au bouton de commutateur (210c) est supprimée, la force de rappel élastique de la partie élastique de support (2420) agit pour déplacer la partie de chargement de corps de support (2435) vers l'extrémité de pointe (2461).

14. Dispositif de commutation combiné selon la revendication 13, comprenant en outre un actionneur haptique (300a, 300c, 300d) disposé dans le corps d'entraînement de commutateur (220c) de manière à être connecté au bouton de commutateur (210c).

15. Dispositif de commutation combiné selon la revendication 13, comprenant en outre une unité d'affichage lumineuse (600) comprenant une lampe optique (620) destinée à générer une lumière et à émettre celle-ci extérieurement sur la base d'un signal électrique de l'unité de commutateur (200c).

16. Module de commutation combiné (1) selon la revendication 1, comprenant :
un boîtier de module (2) dans lequel est monté le dispositif de commutation combiné (10) ;
une unité de commande (20) disposée dans le boîtier de module (2) et configurée pour établir une connexion électrique avec le dispositif de commutation combiné (10) ;
une unité de mémoire (30) configurée pour établir une connexion électrique avec l'unité de commande (20) et stocker des données préétablies pour un mode de fonctionnement correspondant au fonctionnement du dispositif de commutation combiné (10) ; et
une unité d'affichage (50) configurée pour établir une connexion électrique avec l'unité de commande (20) et afficher le mode de fonctionnement du dispositif de commutation combiné (10) sur celle-ci.
